# EUROPEAN PATENT APPLICATION

(11) **EP 4 492 463 A1**
(43) Date of publication of application: **15.01.2025**
(21) Application number: 23790910.6
(22) Date of filing: 06.03.2023
(51) Int. Cl.: H01L 27/105

(54) **MEMORY AND PREPARATION METHOD THEREFOR, AND ELECTRONIC DEVICE**

(30) Priority: 19.04.2022 CN 202210410936
(71) Applicant: Huawei Technologies Co., Ltd., Shenzhen, Guangdong 518129 (CN)
(72) Inventor: TAN, Wanliang, Shenzhen, Guangdong 518129 (CN); ZENG, Sheng, Shenzhen, Guangdong 518129 (CN); LV, Hangbing, Shenzhen, Guangdong 518129 (CN); XU, Jeffrey Junhao, Shenzhen, Guangdong 518129 (CN)
(74) Representative: MERH-IP Matias Erny Reichl Hoffmann Patentanwälte PartG mbB
(86) International application number: PCT/CN2023/079928
(87) International publication number: WO 2023/202249

(57) **Abstract**

Embodiments of this application relate to the field of semiconductor technologies, and disclose a memory and a preparation method therefor, and an electronic device, to improve yields of the memory and the electronic device. The memory includes a first laminated structure, a first passivation part, a functional layer, a first passivation layer, and a second conductive layer. The first laminated structure has a first hole that penetrates the first laminated structure, and the first laminated structure includes a plurality of first conductive layers that are stacked. The first passivation part is located in the first conductive layer and is at a same layer as the first conductive layer. In addition, the first passivation part encircles the first hole, and a material of the first passivation part is oxide of a material of the first conductive layer. The functional layer, the first passivation layer, and the second conductive layer are disposed in the first hole, and are sequentially arranged along a radial direction of the first hole and along a direction from a side wall of the first hole to an axis of the first hole.

## Description

This application claims priority to Chinese Patent Application No. 202210410936.6, filed with the China National Intellectual Property Administration on April 19, 2022 and entitled "MEMORY AND PREPARATION METHOD THEREFOR, AND ELECTRONIC DEVICE", which is incorporated herein by reference in its entirety.

### TECHNICAL FIELD

This application relates to the field of semiconductor technologies, and in particular, to a memory and a preparation method therefor, and an electronic device.

### BACKGROUND

With development of science and technology, digitization processes of all walks of life are accelerating, and exponentially growing massive information and data need to be stored and managed. Compared with rapid development of a chip computing capability and a network cloud storage technology, development of a memory is slower. A person skilled in the art has explored a material, an architecture, a preparation process, and the like of the memory. With improvement of a design capability and a preparation process capability, the architecture of the memory is gradually developed from 2D to 3D, to increase a memory capacity of a cell area of the memory.

A 3D memory usually includes a laminated structure, and the laminated structure has a deep groove structure that penetrates the laminated structure. The 3D memory usually further includes a plurality of film layers covering a side wall of the deep groove structure. A process requirement for depositing and forming, in the deep groove structure, the film layer covering the side wall of the deep groove structure is high, and a yield of the 3D memory is easily affected.

### SUMMARY

Embodiments of this application provide a memory and a preparation method therefor, and an electronic device, to improve yields of the memory and the electronic device.

To achieve the foregoing objectives, the following technical solutions are used in embodiments of this application.

According to a first aspect, a memory is provided. The memory includes a first laminated structure, a first passivation part, a functional layer, a first passivation layer, and a second conductive layer. The first laminated structure has a first hole that penetrates the first laminated structure, and the first laminated structure includes a plurality of first conductive layers that are stacked. The first passivation part is located in the first conductive layer and is at a same layer as the first conductive layer. In addition, the first passivation part encircles the first hole, and a material of the first passivation part is oxide of a material of the first conductive layer. The functional layer, the first passivation layer, and the second conductive layer are disposed in the first hole, and are sequentially arranged along a radial direction of the first hole and along a direction from a side wall of the first hole to an axis of the first hole.

In this application, a first passivation part that is at a same layer as each first conductive layer and that is mutually independent of another first passivation part is disposed at the first conductive layer, so that the first passivation part encircles a first hole. A functional layer, a first passivation layer, and a second conductive layer are sequentially disposed in the first hole, so that not only the first passivation part can separate the first conductive layer from the functional layer, and the first passivation layer can separate the functional layer from the second conductive layer, to avoid impact on performance of the functional layer, improve electrical performance and endurance of the memory, and prolong a service life of the memory, but also the first passivation part that is disposed independently can separate the first conductive layer at the same layer as the first passivation part from another first conductive layer, to avoid short-circuiting formed between a part that is of the first conductive layer and that encircles the first hole and a part that is of the another first conductive layer and that encircles the first hole, and ensure functionality and a yield of the memory.

In addition, in embodiments of this application, a plurality of mutually independent first passivation parts are selectively disposed. Because two adjacent first passivation parts that encircle a same first hole are separated by a second dielectric layer located between the two first passivation parts, short-circuiting, leakage, or mutual interference between different first conductive layers can be avoided. Because the material of the first passivation part is the oxide of the material of the corresponding first conductive layer, there may be a good contact interface between the first passivation part and the first conductive layer. This not only enables the first passivation part and the first conductive layer to be well combined at the interface, but also helps improve forming effect of the functional layer, the first passivation layer, and the second conductive layer that are subsequently formed in the first hole. This helps improve yields of the memory and an electronic device to which the memory is applied.

In a possible implementation of the first aspect, the memory further includes a second laminated structure that is stacked with the first laminated structure. The second laminated structure includes: a first conductive block, a second conductive block, a first dielectric layer, a semiconductor layer, and a third conductive block. The first conductive block is disposed on one side of the first laminated structure. The second conductive block is disposed between the first conductive block and the first laminated structure, and the second conductive block has a second hole. The first dielectric layer and the semiconductor layer are disposed in the second hole, and are sequentially arranged along a radial direction of the second hole and along a direction from a side wall of the second hole to an axis of the second hole. The semiconductor layer is in contact with the first conductive block. The third conductive block is disposed between the second conductive block and the first laminated structure, and the third conductive block is in contact with the semiconductor layer and the second conductive layer. Herein, the second conductive block, the first dielectric layer and the semiconductor layer that are located in the second hole of the second conductive block, the third conductive block electrically connected to the semiconductor layer, and a part that is of the first conductive block and that is electrically connected to the semiconductor layer may form a transistor. Transistors are electrically connected to second conductive layers in first holes in a one-to-one correspondence, and transmit required voltages for the corresponding second conductive layers.

In a possible implementation of the first aspect, the second laminated structure further includes: a second passivation part that is disposed between the first dielectric layer and the second conductive block and that is at a same layer as the second conductive block, and a second passivation layer disposed between the first dielectric layer and the semiconductor layer. A material of the second passivation part is oxide of a material of the second conductive block. In this way, there may be a good contact interface between the second passivation part and the second conductive block. This helps improve forming effect of the first dielectric layer, the second passivation layer, and the semiconductor layer that are subsequently formed, and improve a yield of the memory.

In a possible implementation of the first aspect, the functional layer includes a ferroelectric thin film, a resistive thin film, or a charge trapping layer. In this case, the memory may include a 3D ferroelectric memory, a 3D resistive memory, or a 3D NAND.

In a possible implementation of the first aspect, when the functional layer includes the ferroelectric thin film or the resistive thin film, a material of the second conductive layer includes a metal material. When the functional layer includes the charge trapping layer, a material of the second conductive layer includes a semiconductor material.

In a possible implementation of the first aspect, the material of the first passivation part includes at least one of tungsten oxide, titanium oxynitride, titanium oxide, tantalum oxynitride, tantalum oxide, silicon oxide, copper oxide, silver oxide, hafnium oxide, nickel oxide, ruthenium oxide, iridium oxide, molybdenum oxide, aluminum oxide, magnesium oxide, zinc oxide, and zirconium oxide.

In a possible implementation of the first aspect, the first laminated structure may further include a second dielectric layer disposed between two adjacent first conductive layers. In this way, short-circuiting between the two adjacent first conductive layers can be avoided.

In a possible implementation of the first aspect, the material of the second passivation part includes at least one of tungsten oxide, titanium oxynitride, titanium oxide, tantalum oxynitride, tantalum oxide, silicon oxide, copper oxide, silver oxide, hafnium oxide, nickel oxide, ruthenium oxide, iridium oxide, molybdenum oxide, aluminum oxide, magnesium oxide, zinc oxide, and zirconium oxide.

According to a second aspect, a preparation method for a memory is provided. The preparation method includes: forming a first laminated structure, where the first laminated structure includes a plurality of first conductive layers that are stacked; forming a first hole that penetrates the first laminated structure; performing, via the first hole, oxidation processing on a part that is of the first conductive layer and that encircles the first hole, to form a first passivation part; and sequentially forming a functional layer, a first passivation layer, and a second conductive layer in the first hole.

In this application, oxidation processing is performed on parts that are of the first conductive layers and that encircle the first hole, so that a plurality of mutually independent first passivation parts may be selectively formed in tip areas that are of the first conductive layers and that encircle the first hole. Because the first passivation part in this application is obtained through oxidation processing on the first conductive layer, and different first passivation parts are independent of each other, the first passivation part in this application is at a same layer as the corresponding first conductive layer, and the different first passivation parts are separated. Sizes of the different first passivation parts are uniform along the radial direction of the first hole, instead of continuously covering the side wall of the first hole. This can avoid leakage between the different first conductive layers and interference caused by leakage.

In addition, in this application, the first passivation part is used, so that not only pollution caused by introduction of another element oxide can be avoided, but also good contact between the first passivation part and the first conductive layer can be ensured, thereby avoiding a problem that the first passivation part is difficult to be in good contact with the first conductive layer because the passivation layer is uneven in thickness. In addition, in this application, this not only can simplify the preparation method for a memory, but also can improve yields of the functional layer, the first passivation layer, and the second conductive layer that are subsequently deposited and formed in the first hole, and further improve a yield of the prepared memory.

In a possible implementation of the second aspect, before the forming a first laminated structure, the preparation method further includes: forming a first conductive block; forming a second conductive block on the first conductive block; forming a second hole that penetrates the second conductive block, where the second hole exposes a part of the first conductive block; sequentially forming a first dielectric layer and a semiconductor layer in the second hole; and forming a third conductive block on the first dielectric layer and the semiconductor layer, where the third conductive block is in contact with the semiconductor layer. In this way, a transistor may be formed to transmit a required voltage for a corresponding second conductive layer.

In a possible implementation of the second aspect, before the sequentially forming a first dielectric layer and a semiconductor layer in the second hole, the preparation method further includes: performing, via the second hole, oxidation processing on a part that is of the second conductive block and that encircles the second hole, to form a second passivation part. Before the forming a semiconductor layer, the preparation method further includes: forming a second passivation layer. The second passivation part is formed between the first dielectric layer and the second conductive block, to avoid impact on performance of the first dielectric layer and the second conductive block. The second passivation layer is formed between the first dielectric layer and the semiconductor layer, to avoid impact on performance of the first dielectric layer and the semiconductor layer. In this way, performance and a service life of the prepared memory can be avoided. In addition, the second passivation part is obtained after oxidation processing is performed on the part that is of the second conductive block and that encircles the second hole. Therefore, the second conductive block and the second passivation part are of an integrated structure, so that the second conductive block and the second passivation part can be better combined.

According to a third aspect, a preparation method for a memory is provided. The preparation method includes: forming a first laminated structure, where the first laminated structure includes a plurality of first composite layers that are stacked, the first composite layer includes a first passivation part and a first conductive layer that encircles the first passivation part, and a material of the first passivation part is oxide of a material of the first conductive layer; forming a first hole that penetrates the first passivation part; and sequentially forming a functional layer, a first passivation layer, and a second conductive layer in the first hole.

In this application, a plurality of mutually independent first passivation parts may be selectively disposed in first conductive layers based on positions of to-be-formed first holes, so that in this application, the first passivation part and the first conductive layer are located at a same layer, different first passivation parts located at different layers are separated by a second dielectric layer, and the first passivation parts located at the different layers are penetrated to form the first hole. Therefore, in this application, the different first passivation parts are separated, sizes of the different first passivation parts are uniform along a radial direction of the first hole, instead of continuously covering a side wall of the first hole. This can avoid leakage between the different first conductive layers and interference caused by leakage.

In addition, in this application, the first passivation part is used, so that not only pollution caused by introduction of another element oxide can be avoided, but also good contact between the first passivation part and the first conductive layer can be ensured, thereby avoiding a problem that the first passivation part is difficult to be in good contact with the first conductive layer because the passivation layer is uneven in thickness. In addition, in this application, this not only can simplify the preparation method for a memory, but also can improve yields of the functional layer, the first passivation layer, and the second conductive layer that are subsequently deposited and formed in the first hole, and further improve a yield of the prepared memory.

In a possible implementation of the third aspect, forming the first composite layer includes: forming a first conductive thin film; patterning the first conductive thin film to form a first opening, to obtain the first conductive layer; and forming the first passivation part in the first opening.

In a possible implementation of the third aspect, forming the first composite layer includes: forming a first stripping layer, where the first stripping layer has a second opening corresponding to a to-be-formed first passivation part; forming a first passivation thin film on the first stripping layer; and removing the first stripping layer and a part that is of the first passivation thin film and that covers the first stripping layer, to obtain the first passivation part; and forming a second stripping layer on the first passivation part, where an orthographic projection of the second stripping layer on a reference plane coincides with an orthographic projection of the first passivation part on the reference plane, and the reference plane is a plane on which the memory is located; forming a first conductive thin film on the second stripping layer; and removing the second stripping layer and a part that is of the first conductive thin film and that covers the second stripping layer, to obtain the first conductive layer; or forming a first conductive thin film on the first passivation part; and polishing the first conductive thin film, and removing a part that is of the first conductive thin film and that covers the first passivation part, to obtain the first conductive layer.

In a possible implementation of the third aspect, forming the first composite layer includes: forming a first conductive thin film; disposing a mask on the first conductive thin film, where the mask has a third opening corresponding to a to-be-formed first passivation part; and performing oxidation processing on the first conductive thin film via the third opening of the mask, to form the first passivation part.

In a possible implementation of the third aspect, before the forming a first laminated structure, the preparation method further includes: forming a first conductive block; forming a second conductive block on the first conductive block; forming a second hole that penetrates the second conductive block, where the second hole exposes a part of the first conductive block; sequentially forming a first dielectric layer and a semiconductor layer in the second hole; and forming a third conductive block on the first dielectric layer and the semiconductor layer, where the third conductive block is in contact with the semiconductor layer.

In a possible implementation of the third aspect, before the forming a first laminated structure, the preparation method further includes: forming a first conductive block; forming a second composite layer on the first conductive block, where the second composite layer includes a second passivation part and a second conductive block that encircles the second passivation part, and a material of the second passivation part is oxide of a material of the second conductive block; forming a second hole that penetrates the second passivation part, where the second hole exposes a part of the first conductive block; and sequentially forming a first dielectric layer, a second passivation layer, and a semiconductor layer in the second hole.

According to a fourth aspect, an electronic device is provided. The electronic device includes a processor and a memory coupled to the processor. The memory includes the memory according to any implementation of the first aspect.

For technical effect achieved in any design manner of the fourth aspect, refer to the technical effect achieved in different design manners of the first aspect. Details are not described herein again.

### BRIEF DESCRIPTION OF DRAWINGS

FIG. 1 is a diagram of a structure of an electronic device according to an embodiment of this application;
FIG. 2 is a diagram of a structure of a ferroelectric capacitor according to an embodiment of this application;
FIG. 3 is a diagram of a structure of another ferroelectric capacitor according to an embodiment of this application;
FIG. 4 is a diagram of a structure of still another ferroelectric capacitor according to an embodiment of this application;
FIG. 5 is an equivalent circuit diagram of a 3D ferroelectric memory according to an embodiment of this application;
FIG. 6 is a diagram of a partial structure of a 3D ferroelectric memory according to an embodiment of this application;
FIG. 7 is a diagram of a partial structure of a 3D ferroelectric memory according to an implementation;
FIG. 8 is a diagram of a partial structure of another 3D ferroelectric memory according to an implementation;
FIG. 9 is a diagram of a structure of a memory according to an embodiment of this application;
FIG. 10 is a diagram of a partial structure of a memory according to an embodiment of this application;
FIG. 11 is a sectional view of a memory according to an embodiment of this application;
FIG. 12 is a diagram of a structure of another memory according to an embodiment of this application;
FIG. 13 is a sectional view of another memory according to an embodiment of this application;
FIG. 14 is a flowchart of a preparation method for a memory according to an embodiment of this application;
FIG. 15a to FIG. 15e are step diagrams of a preparation procedure of a transistor according to an embodiment of this application;
FIG. 16a to FIG. 16c are step diagrams of another preparation procedure of a transistor according to an embodiment of this application;
FIG. 17a to FIG. 17d are step diagrams of a preparation procedure of a memory according to an embodiment of this application;
FIG. 18 is a flowchart of another preparation method for a memory according to an embodiment of this application;
FIG. 19a to FIG. 19c are step diagrams of another preparation procedure of a memory according to an embodiment of this application;
FIG. 20a to FIG. 20c are step diagrams of a preparation procedure of a first composite layer according to an embodiment of this application;
FIG. 21a to FIG. 21f are step diagrams of another preparation procedure of a first composite layer according to an embodiment of this application;
FIG. 22a and FIG. 22b are step diagrams of another preparation procedure of a first composite layer according to an embodiment of this application;
FIG. 23a and FIG. 23b are step diagrams of another preparation procedure of a first composite layer according to an embodiment of this application; and
FIG. 24a and FIG. 24b are step diagrams of another preparation procedure of a transistor according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In the descriptions of this application, unless otherwise specified, "a plurality of" means two or more. "At least one of the following items (pieces)" or a similar expression thereof refers to any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural.

In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not constitute a limitation on a quantity or an execution sequence, and that the terms such as "first" and "second" do not indicate a definite difference. In addition, in embodiments of this application, the word such as "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word such as "example" or "for example" is intended to present a relative concept in a specific manner for ease of understanding.

In embodiments of this application, "up", "down", "left", and "right" are not limited to orientations of schematically placed components in relative accompanying drawings. It should be understood that these orientation terms may be relative concepts. The orientation terms are used for relative description and clarification, and may vary correspondingly based on a change in an orientation in which the component is placed in the accompanying drawings. In the accompanying drawings, for clarity, thicknesses of layers and regions are exaggerated, and a size proportion relationship between parts in the figures does not reflect an actual size proportion relationship.

In addition, an architecture and a scenario described in embodiments of this application are intended to describe the technical solutions in embodiments of this application more clearly, and do not constitute a limitation on the technical solutions provided in embodiments of this application. A person of ordinary skill in the art may know that: With the evolution of the architecture and the emergence of new scenarios, the technical solutions provided in embodiments of this application are also applicable to similar technical problems.

An embodiment of this application provides an electronic device. The electronic device may be a mobile phone (mobile phone), a tablet computer (pad), a television, a desktop computer, a laptop computer, a handheld computer, a notebook computer, an ultra-mobile personal computer (ultra-mobile personal computer, UMPC), a netbook, a cellular phone, a personal digital assistant (personal digital assistant, PDA), an augmented reality (augmented reality, AR) device, a virtual reality (virtual reality, VR) device, an artificial intelligence (artificial intelligence, AI) device, a smart wearing device (for example, a smartwatch and a smart band), an in-vehicle device, a smart home device, and/or a smart city device, and a specific type of the electronic device is not specifically limited in embodiments of this application.

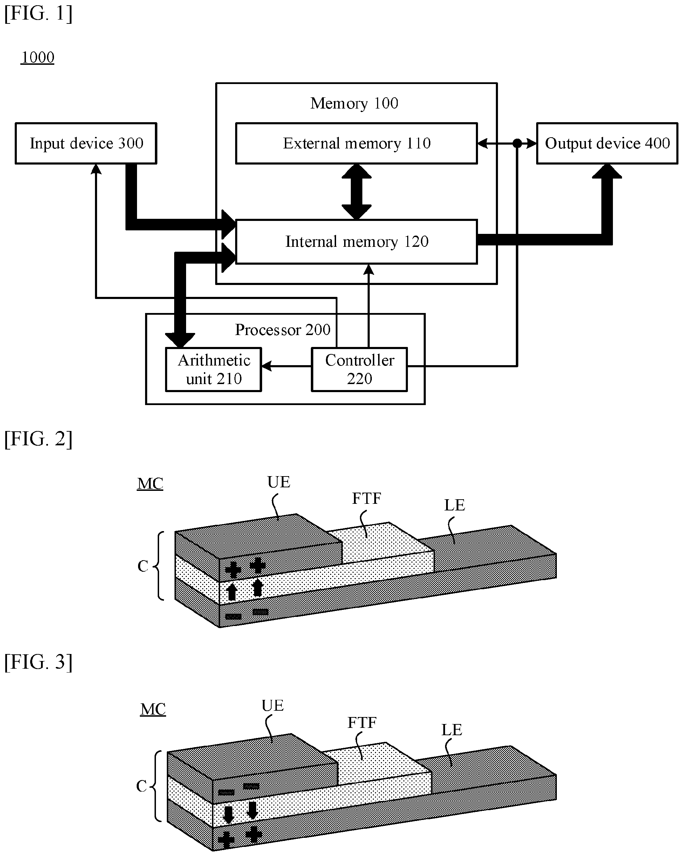

FIG. 1 is a diagram of an architecture of an example of an electronic device according to an embodiment of this application. As shown in FIG. 1, an electronic device 1000 includes components such as a memory 100, a processor 200, an input device 300, and an output device 400. A person skilled in the art may understand that a structure of the electronic device shown in FIG. 1 does not constitute any limitation on the electronic device 1000, and the electronic device 1000 may include more or fewer components than those shown in FIG. 1, or may include a combination of some of the components shown in FIG. 1, or may include components arranged differently from those shown in FIG. 1.

The memory 100 is configured to store a software program and a module. The memory 100 mainly includes a program storage area and a data storage area. The program storage area may store an operating system, an application required by at least one function (such as a sound playing function and an image playing function), and the like. The data storage area may store data (such as audio data, image data, and a phone book) created based on use of the electronic device, and the like. In addition, the memory 100 includes an external memory 110 and an internal memory 120. Data stored in the external memory 110 and the internal memory 120 may be transmitted to each other. The external memory 110 includes, for example, a hard disk, a USB flash drive, and a floppy disk. The internal memory 120 includes, for example, a static random access memory (static random access memory, SRAM), a dynamic random access memory (dynamic random access memory, DRAM), a read-only memory, and the like.

The processor 200 is a control center of the electronic device 1000, and connects various parts of the entire electronic device 1000 through various interfaces and lines. By running or executing the software program and/or the module stored in the memory 100, and invoking data stored in the memory 100, the processor 200 performs various functions of the electronic device 1000 and processes data, thereby performing overall monitoring on the electronic device 1000. Optionally, the processor 200 may include one or more processing units. For example, the processor 200 may include a central processing unit (central processing unit, CPU), an artificial intelligence (artificial intelligence, AI) processor, a digital signal processor (digital signal processor, DSP), and a neural-network processing unit, or may be another application-specific integrated circuit (application-specific integrated circuit, ASIC). In FIG. 1, an example in which the processor 200 is a CPU is used, and the CPU may include an arithmetic unit 210 and a controller 220. The arithmetic unit 210 obtains data stored in the internal memory 120, and processes the data stored in the internal memory 120. A processed result is usually sent back to the internal memory 120. The controller 220 may control the arithmetic unit 210 to process the data, and the controller 220 may further control the external memory 110 and the internal memory 120 to store data or read data.

The input device 300 is configured to: receive input digit or character information, and generate key signal input related to user settings and function control of the electronic device 1000. For example, the input device 300 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any proper object or accessory such as a finger or a stylus pen), and drive a corresponding connection apparatus based on a preset program. Optionally, the touchscreen may include two parts: a touch detection apparatus and a touch controller. The touch detection apparatus detects a touch position of the user, detects a signal brought by the touch operation, and transfers the signal to the touch controller. The touch controller receives touch information from the touch detection apparatus, converts the touch information into coordinates of a touch point, and sends the coordinates to the processor 200. In addition, the touch controller can receive and execute a command sent by the processor 200. In addition, the touchscreen may be implemented in a plurality of types, such as a resistive type, a capacitive type, an infrared ray type, and a surface acoustic wave type. The another input device may include but is not limited to one or more of a physical keyboard, a function key (such as a volume control key or a power on/off key), a trackball, a mouse, a joystick, or the like. The controller 220 in the processor 200 may further control the input device 300 to receive an input signal or not to receive an input signal. In addition, the input digit or character information received by the input device 300 and the key signal input related to user settings and function control of the electronic device may be stored in the internal memory 120.

The output device 400 is configured to output a signal corresponding to data that is input by the input device 300 and stored in the internal memory 120. For example, the output device 400 outputs a sound signal or a video signal. The controller 220 in the processor 200 may further control the output device 400 to output a signal or not to output a signal.

It should be noted that a thick arrow in FIG. 1 indicates data transmission, and a direction of the thick arrow indicates a data transmission direction. For example, a unidirectional arrow between the input device 300 and the internal memory 120 indicates that data received by the input device 300 is transmitted to the internal memory 120. For another example, a bidirectional arrow between the arithmetic unit 210 and the internal memory 120 indicates that the data stored in the internal memory 120 may be transmitted to the arithmetic unit 210, and data processed by the arithmetic unit 210 may be transmitted to the internal memory 120. A thin arrow in FIG. 1 indicates a component that can be controlled by the controller 220. For example, the controller 220 may control the external memory 110, the internal memory 120, the arithmetic unit 210, the input device 300, the output device 400, and the like.

Optionally, the electronic device 1000 shown in FIG. 1 may further include various sensors, for example, a gyro sensor, a hygrometer sensor, an infrared sensor, and a magnetometer sensor. Details are not described herein. Optionally, the electronic device 1000 may further include a wireless fidelity (wireless fidelity, Wi-Fi) module, a Bluetooth module, and the like. Details are not described herein.

It may be understood that a memory provided in embodiments of this application may be used as the memory 100 in the electronic device 1000. For example, the memory provided in embodiments of this application may be used as the external memory 110 in the memory 100, or may be used as the internal memory 120 in the memory 100. In addition, the memory provided in this application may be used in an independent memory cell, to replace various DRAM components in a DRAM system.

The memory provided in embodiments of this application may be a ferroelectric random access memory (ferroelectric random access memory, FeRAM), a resistive random access memory (resistive random access memory, RRAM), a NAND flash (NAND flash, NAND) memory, a NOR flash (NOR flash, NOR) memory, or the like. The ferroelectric random access memory may be referred to as a ferroelectric memory for short, and the resistive random access memory may be referred to as a resistive memory for short.

The memory provided in embodiments of this application may be a 3D memory, for example, a 3D DRAM, a 3D FeRAM, a 3D RRAM, a 3D NAND, or a 3D NOR.

For example, a memory cell of the memory provided in embodiments of this application includes two conductive layers that are disposed opposite to each other, and a memory functional layer disposed between the two conductive layers. An electric field is formed between the two conductive layers, so that a state of the memory functional layer can be changed, and data storage can be implemented based on change of the state of the memory functional layer.

In embodiments of this application, the ferroelectric memory is used as an example for schematic description. It may be understood that the ferroelectric memory has a plurality of advantages, which are conducive to changing a dilemma of an existing memory. For example, the ferroelectric memory not only has non-volatility, but also has good performance. For example, the ferroelectric memory has performance such as a low operating voltage and power, low power consumption, a high read/write speed, and good endurance. In addition, the ferroelectric memory can be integrated with an advanced process to form a 3D structure, to achieve a huge memory capacity.

For example, as shown in FIG. 2 and FIG. 3, in the memory cell MC of the ferroelectric memory, the two conductive layers may include a lower electrode LE and an upper electrode UE, and the memory functional layer may include a ferroelectric thin film FTF. Materials of the lower electrode LE and the upper electrode UE may both be metal (Metal) materials, and a material of the ferroelectric thin film FTF includes a ferroelectric (Ferroelectric) material. The ferroelectric thin film FTF may be used as an insulation medium, so that the lower electrode LE, the ferroelectric thin film FTF, and the upper electrode UE may form a ferroelectric capacitor C, and the ferroelectric capacitor C is of a metal-ferroelectric-metal (metal-ferroelectric-metal, MFM) structure. Certainly, the ferroelectric capacitor C may further include another film layer. For details, refer to the following description. Details are not described herein.

The ferroelectric memory uses, for data storage, a characteristic that the ferroelectric material can be spontaneously polarized and a polarization state can be reoriented under an action of an external electric field.

For example, as shown in FIG. 2, when a voltage of the upper electrode UE is a positive voltage, and a voltage of the lower electrode LE is a negative voltage, under an action of an electric field formed by the upper electrode UE and the lower electrode LE, a polarity of the ferroelectric material in the ferroelectric thin film FTF points to upper (that is, points to the upper electrode UE). As shown in FIG. 3, when a voltage of the upper electrode UE is a negative voltage, and a voltage of the lower electrode LE is a positive voltage, under an action of an electric field formed by the upper electrode UE and the lower electrode LE, a polarity of the ferroelectric material in the ferroelectric thin film FTF points to lower (that is, points to the lower electrode LE).

Specifically, when an electric field is applied to a ferroelectric material, a central atom of the electric field stays at a low-energy state position along a direction of the electric field. On the contrary, when the electric field is switched and applied to the same ferroelectric material, the central atom of the electric field moves in a crystal along the direction of the electric field and stays at another low-energy state position. A large quantity of central atoms move and are coupled in a cell of the crystal to form a ferroelectric domain (ferroelectric domain), and the ferroelectric domain forms a polarization charge (also called a switching charge) under an action of the electric field.

More switching charges are formed when the ferroelectric domain is switched under the action of the electric field, and fewer switching charges are formed when the ferroelectric domain is not switched under the action of the electric field. A binary stable state of the ferroelectric material enables the ferroelectric material to be used as a memory. Different switching charges are generated when different strength directions of remnant polarization are used and an electric field is applied in a same direction, which may be used to store data "0" and " 1".

When an electric field is added to a ferroelectric material crystal, a central atom moves in the crystal along a direction of the electric field. After the electric field is removed, the central atom can keep a position unchanged, and a polarization state remains. Therefore, the ferroelectric material has a non-volatile characteristic when used as a memory.

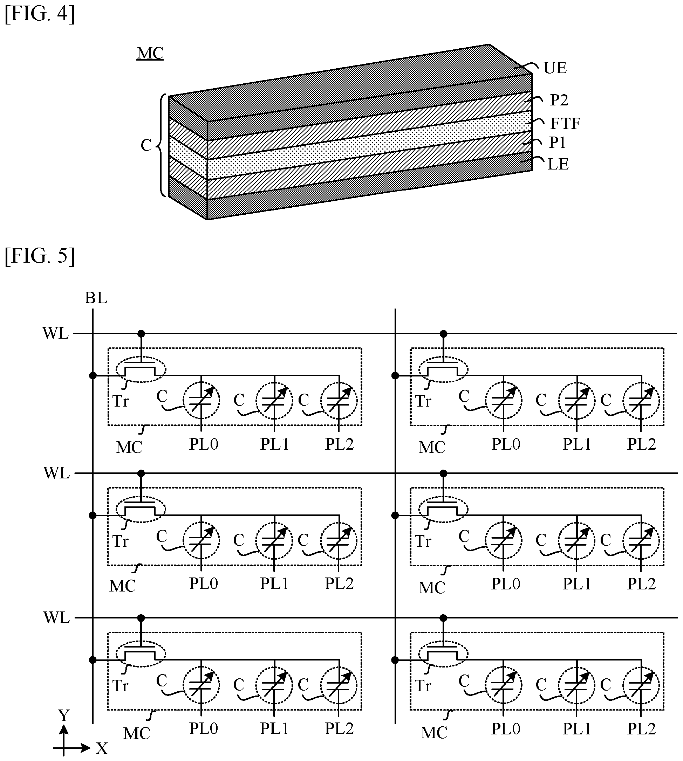

For example, as shown in FIG. 4, the ferroelectric capacitor C may further include a passivation layer P1 located between the lower electrode LE and the ferroelectric thin film FTF, and another passivation layer P2 located between the ferroelectric thin film FTF and the upper electrode UE. Materials of the passivation layers P1 and P2 include insulation (insulation) materials, and the insulation material includes, for example, oxide (oxide). In this case, the ferroelectric capacitor C is of a metal-oxide-ferroelectric-oxide-metal (metal-oxide-ferroelectric-oxide-metal, MOFOM) structure.

It may be understood that a structure and performance of the foregoing oxide are stable. The passivation layer P1 is disposed between the lower electrode LE and the ferroelectric thin film FTF, so that the passivation layer P1 can isolate the lower electrode LE from the ferroelectric thin film FTF. In this way, not only a case in which a defect is formed in the ferroelectric thin film FTF because the lower electrode LE captures oxygen from the ferroelectric thin film FTF can be avoided, but also a case in which performance of the ferroelectric thin film FTF is affected because a metal element in the lower electrode LE penetrates into the ferroelectric thin film FTF can be avoided. The passivation layer P2 is disposed between the upper electrode UE and the ferroelectric thin film FTF, so that the passivation layer P2 can isolate the upper electrode UE from the ferroelectric thin film FTF. In this way, not only a case in which a defect is formed in the ferroelectric thin film FTF because the upper electrode UE captures oxygen from the ferroelectric thin film FTF can be avoided, but also a case in which performance of the ferroelectric thin film FTF is affected because a metal element in the upper electrode UE penetrates into the ferroelectric thin film FTF can be avoided.

In other words, the ferroelectric capacitor C of the MOFOM structure can effectively protect an interface of the ferroelectric thin film FTF. In this way, a case in which polarization switching cannot be performed due to a dead layer is avoided, electrical performance and endurance of a device (that is, the ferroelectric capacitor or the ferroelectric memory) are improved, and a service life of the device (that is, the ferroelectric capacitor or the ferroelectric memory) is prolonged.

For example, FIG. 5 is an equivalent circuit diagram of a 3D ferroelectric memory. The 3D ferroelectric memory includes a plurality of memory cells MCs disposed in an array, and each memory cell MC includes at least two ferroelectric capacitors Cs. For example, each memory cell MC may include two, three, four, or even more ferroelectric capacitors Cs. Each ferroelectric capacitor C may be configured to store 1-bit data, and each memory cell MC in the 3D ferroelectric memory includes at least two ferroelectric capacitors Cs. In this way, each memory cell MC may be configured to store multi-bit data. This helps increase a memory capacity of each memory cell MC and further helps increase a memory capacity of the 3D ferroelectric memory.

As shown in FIG. 5, the 3D ferroelectric memory further includes a plurality of signal lines, where the plurality of signal lines include a plurality of word lines WL extending along a first direction X, and a plurality of bit lines BL and a plurality of plate lines PL extending along a second direction Y The plate line PL is, for example, located in a plane determined based on the first direction X and the second direction Y

For example, FIG. 5 shows an example of six memory cells MCs in the 3D ferroelectric memory, and each memory cell MC includes three ferroelectric capacitors Cs. A first end (for example, an upper electrode UE) of each ferroelectric capacitor C may be shared, and a second end (for example, a lower electrode LE) of each ferroelectric capacitor C may be separately connected to different signal lines (for example, plate lines PL0, PL1, and PL2 shown in FIG. 5).

For example, as shown in FIG. 5, the memory cell MC further includes a transistor Tr. The transistor Tr may be an NMOS (N-channel metal oxide semiconductor, N-channel metal oxide semiconductor) transistor, or may be a PMOS (P-channel metal oxide semiconductor, P-channel metal oxide semiconductor) transistor.

In each memory cell MC, a gate of the transistor Tr is electrically connected to a word line WL, a first electrode of the transistor Tr is electrically connected to a bit line BL, and a second electrode of the transistor Tr is electrically connected to a first end of each ferroelectric capacitor C included in the memory cell MC. In the 3D ferroelectric memory, gates of transistors Tr of a same row of memory cells MCs are electrically connected to a same word line WL, and first electrodes of transistors Tr of a same column of memory cells MCs are electrically connected to a same bit line BL. In this application, one of a drain (drain) or a source (source) of the transistor Tr is the first electrode, and the other is the second electrode.

It may be understood that, in the 3D ferroelectric memory, there are a plurality of structures of the memory cell MC and electrical connection relationships between the MC and signal lines, which are not limited thereto.

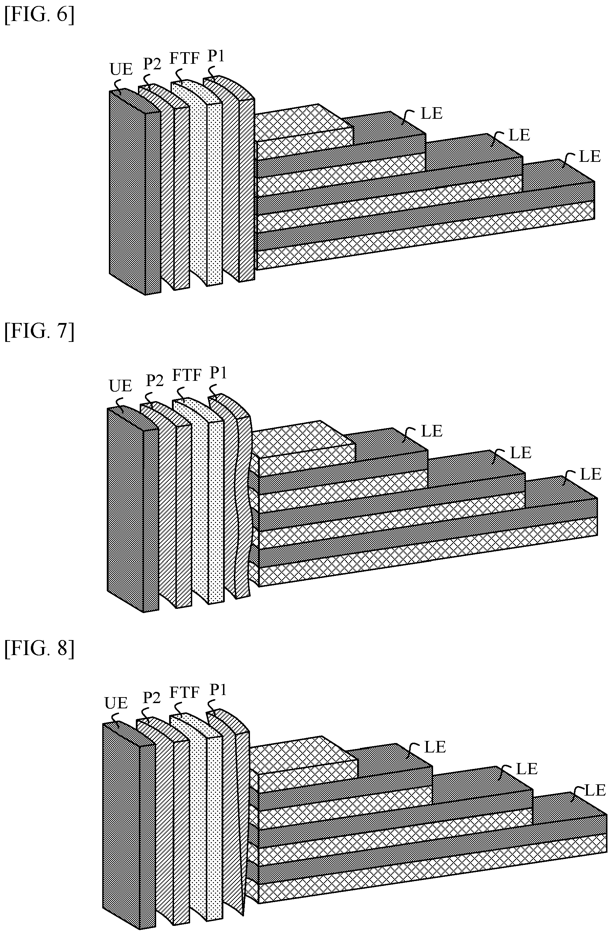

In an implementation, in a process of preparing the 3D ferroelectric memory, a plurality of layers of lower electrodes LEs that are stacked are first formed, then vertical puncturing is performed on the plurality of layers of lower electrodes LEs to form a deep groove structure that penetrates the plurality of layers of lower electrodes LEs, and then the passivation layer P1, the ferroelectric thin film FTF, the passivation layer P2, and the upper electrode UE are sequentially formed in the deep groove structure. FIG. 6 to FIG. 8 each show a partial structure of a prepared 3D ferroelectric memory.

It may be understood that a shape of a film layer has large impact on a yield of the 3D ferroelectric memory, and a process of preparing and forming the 3D ferroelectric memory is complex. The passivation layer P1 has significant impact on the yield of the 3D ferroelectric memory. For example, it is difficult to form the passivation layer P1 on a vertical side wall of a deep-hole structure (or may be referred to as the deep groove structure), there are few processes for forming the passivation layer P1 on the vertical side wall of the deep groove structure, it is very difficult to control thickness uniformity of the passivation layer P1, and thickness uniformity of the passivation layer P1 is easily reduced. For example, the passivation layer P1 is in a wave shape as a whole (for example, in a partial structure of the 3D ferroelectric memory shown in FIG. 7, a part of an interface of the passivation layer P1 is convex or concave). For another example, a part of the passivation layer P1 is small in thickness, the other part is large in thickness (as shown in FIG. 8, in a partial structure of the 3D ferroelectric memory, the passivation layer P1 is wedge-shaped, a lower part of the passivation layer P1 is small in thickness, and an upper part of the passivation layer P1 is large in thickness). In this way, not only contact effect between the passivation layer P1 and the side wall of the deep groove structure is affected, and consequently different lower electrodes LEs are leaked and short-circuited via the passivation layer P1, but also formation effect of the ferroelectric thin film FTF is easily affected. In addition, when a material of the passivation layer P1 includes an amorphous material, and the passivation layer P1 is small in thickness, tunneling effect of the passivation layer P1 is obvious. This easily causes short-circuiting, open-circuiting, mutual interference, or the like between the different lower electrodes LEs. This reduces the yield of the 3D ferroelectric memory.

Based on this, some embodiments of this application provide a memory. The memory is, for example, a 3D memory. A type of the memory includes, for example, a 3D DRAM, a 3D FeRAM, a 3D RRAM, a 3D NAND, or a 3D NOR.

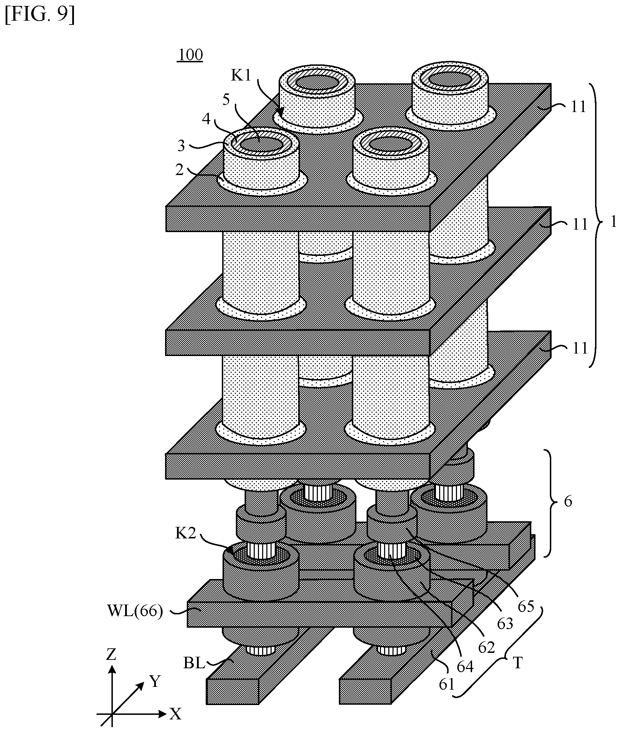

In some examples, as shown in FIG. 9 to FIG. 13, the memory 100 includes a first laminated structure 1, and the first laminated structure 1 includes a plurality of first conductive layers 11 that are stacked.

A material of the first conductive layer 11 includes a conductive material, for example, may include at least one of conductive materials such as tungsten (W), titanium nitride (TiN), titanium (Ti), tantalum nitride, tantalum (Ta), copper (Cu), silver (Ag), hafnium nitride (HfN), nickel (Ni), ruthenium (Ru), iridium (Ir), molybdenum, aluminum, magnesium, zinc, zirconium, or doped silicon or polycrystalline silicon. Materials of the foregoing plurality of first conductive layers 11 may be the same or may be different.

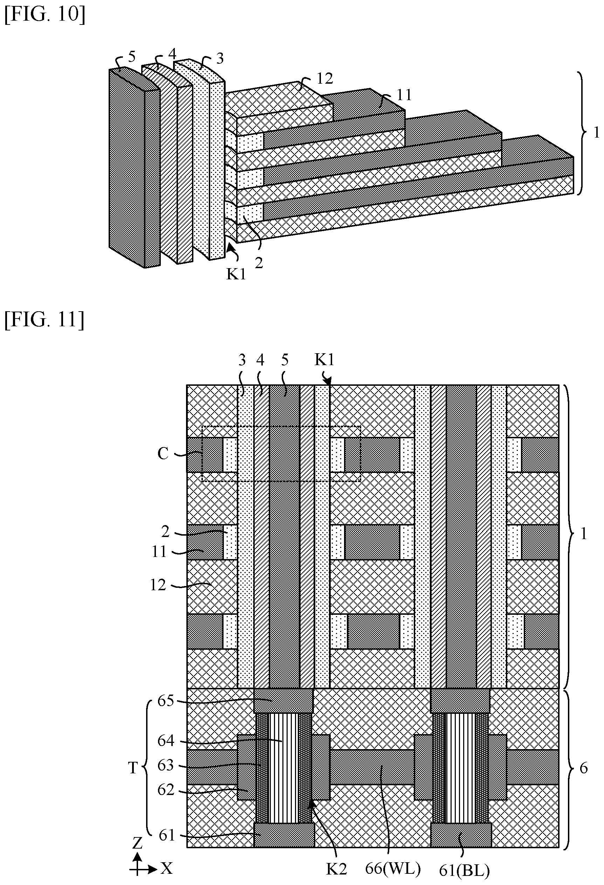

In the foregoing plurality of first conductive layers 11, any two adj acent first conductive layers 11 are insulated from each other. Therefore, as shown in FIG. 10, FIG. 11, and FIG. 13, the first laminated structure 1 further includes a second dielectric layer 12 disposed between two adjacent first conductive layers 11. In this way, short-circuiting between the two adjacent first conductive layers 11 can be avoided.

A material of the second dielectric layer 12 includes, for example silicon oxide (for example, silicon dioxide SiO₂) or aluminum oxide.

In the first laminated structure 1, thicknesses of the first conductive layers 11 may be the same or different, and thicknesses of second dielectric layers 12 may be the same or different, which may be specifically set based on an actual requirement. In addition, in a production process of the first laminated structure 1, different quantities of stacked layers correspond to different stacking heights. For example, a quantity of stacked film layers of the first laminated structure 1 may be dozens of or even hundreds of layers (for example, 32, 64, or 128 layers). A larger quantity of film layers included in the first laminated structure 1 indicates a higher integration level and a larger memory capacity of the memory. Specifically, a quantity of stacked layers and a stacking height of the first laminated structure 1 may be designed based on an actual memory requirement. This is not limited in this application.

In addition, each first conductive layer 11 and each second dielectric layer 12 in the first laminated structure 1 have high flatness, and a first conductive layer 11 and a second dielectric layer 12 that are adjacent have good adhesion and basically have no gap.

For example, as shown in FIG. 9 to FIG. 13, the first laminated structure 1 has a first hole K1 that penetrates the first laminated structure 1. In other words, the first hole K1 penetrates the first laminated structure 1. Specifically, the first hole K1 may penetrate the first conductive layer 11 and the second dielectric layer 12 that are included in the first laminated structure 1.

The first hole K1 has a uniform aperture or a uniformly-changed aperture, and the first hole K1 has good straightness.

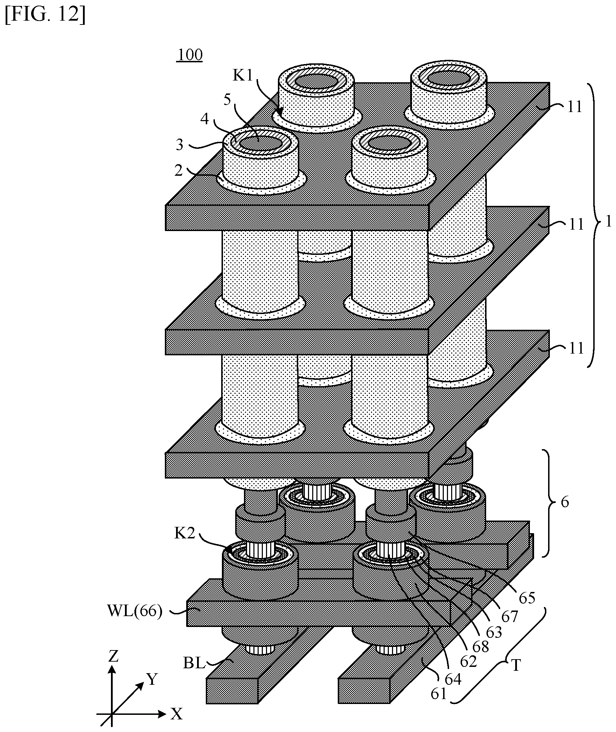

Herein, there are a plurality of first holes K1. It may be understood that a larger quantity of first holes K1 indicates a higher integration level of the memory and a larger quantity of memory cells formed by the memory. Specifically, the quantity of first holes K1 may be designed based on an actual storage requirement. This is not limited in this application. FIG. 9 and FIG. 12 show four first holes K1.

Shapes of the first conductive layer 11, the second dielectric layer 12, and the first hole K1 in the first laminated structure 1 are disposed, so that a risk of forming short-circuiting or generating interference between memory cells can be reduced.

In some examples, as shown in FIG. 9 to FIG. 13, the memory 100 further includes a first passivation part 2 that is located in the first conductive layer 11 and that is at a same layer as the first conductive layer 11. The first passivation part 2 encircles the first hole K1. The first passivation part 2 is, for example, in a ring shape.

For example, a plurality of first passivation parts 2 are disposed at a same layer as each first conductive layer 11. The first passivation part 2 encircles the first hole K1, which means that the first hole K1 may penetrate the first passivation part 2, and the first passivation part 2 may separate the first hole K1 from the first conductive layer 11. A quantity of first passivation parts 2 disposed at the same layer as each first conductive layer 11 may be the same as the quantity of first holes K1. In addition, in a third direction Z, a plurality of first passivation parts 2 that encircle a same first hole K1 and correspond to different first conductive layers 11 are disposed opposite to each other. Correspondingly, a side wall of each first hole K1 may include a surface that is of the second dielectric layer 12 and that encircles the first hole K1 and a surface that is of the first passivation part 2 and that encircles the first hole K1.

The foregoing "same layer" means that the first passivation part 2 and the corresponding first conductive layer 11 are located at a same layer. In the third direction Z, two adjacent first passivation parts 2 are separated by a second dielectric layer 12 between the two first passivation parts 2. Correspondingly, at a position of the first hole K1, the first passivation part 2 may separate a part that is of the first conductive layer 11 and that is at a same layer as the first passivation part 2 and that encircles the first hole K1 and a part that is of another first conductive layer 11 and that encircles the first hole K1, so that short-circuiting formed between the first conductive layer 11 and the another first conductive layer 11 is avoided.

For example, a material of the first passivation part 2 is oxide of a material of the first conductive layer 11. In other words, the material of the first passivation part 2 matches the material of the first conductive layer 11 at the same layer as the first passivation part 2.

For example, the material of the first passivation part 2 includes at least one of tungsten oxide (WO₃), titanium oxynitride, titanium oxide (TiO₂), tantalum oxynitride, tantalum oxide, silicon oxide, copper oxide, silver oxide, hafnium oxide, nickel oxide, ruthenium oxide, iridium oxide, molybdenum oxide, aluminum oxide, magnesium oxide, zinc oxide, and zirconium oxide. The material of the first passivation part 2 in this application is not limited thereto.

If the material of the first conductive layer 11 is tungsten, the material of the first passivation part 2 at the same layer as the first conductive layer 11 is tungsten oxide; or if the material of the first conductive layer 11 is titanium nitride, the material of the first passivation part 2 at the same layer as the first conductive layer 11 is titanium oxynitride; or if the material of the first conductive layer 11 is titanium, the material of the first passivation part 2 at the same layer as the first conductive layer 11 is titanium oxide; or if the material of the first conductive layer 11 is tantalum nitride, the material of the first passivation part 2 that is at the same layer as the first conductive layer 11 is tantalum oxynitride; or if the material of the first conductive layer 11 is tantalum, the material of the first passivation part 2 at the same layer as the first conductive layer 11 is tantalum oxide; or if the material of the first conductive layer 11 is copper, the material of the first passivation part 2 at the same layer as the first conductive layer 11 is copper oxide; or if the material of the first conductive layer 11 is silver, the material of the first passivation part 2 at the same layer as the first conductive layer 11 is silver oxide; or if the material of the first conductive layer 11 is hafnium nitride, the material of the first passivation part 2 at the same layer as the first conductive layer 11 is hafnium oxide; or if the material of the first conductive layer 11 is nickel, the material of the first passivation part 2 at the same layer as the first conductive layer 11 is nickel oxide; or if the material of the first conductive layer 11 is ruthenium, the material of the first passivation part 2 at the same layer as the first conductive layer 11 is ruthenium oxide; or if the material of the first conductive layer 11 is iridium, the material of the first passivation part 2 at the same layer as the first conductive layer 11 is iridium oxide; or if the material of the first conductive layer 11 is molybdenum, the material of the first passivation part 2 at the same layer as the first conductive layer 11 is molybdenum oxide; or if the material of the first conductive layer 11 is aluminum, the material of the first passivation part 2 at the same layer as the first conductive layer 11 is aluminum oxide; or if the material of the first conductive layer 11 is magnesium, the material of the first passivation part 2 at the same layer as the first conductive layer 11 is magnesium oxide; or if the material of the first conductive layer 11 is zinc, the material of the first passivation part 2 at the same layer as the first conductive layer 11 is zinc oxide; or if the material of the first conductive layer 11 is zirconium, the material of the first passivation part 2 at the same layer as the first conductive layer 11 is zirconium oxide; or if the material of the first conductive layer 11 is doped silicon or polycrystalline silicon, the material of the first passivation part 2 at the same layer as the first conductive layer 11 is silicon oxide.

By pairing the material of the first passivation part 2 with the material of the first conductive layer 11 at the same layer as the first passivation part 2, main elements of the materials of the first passivation part 2 and the first conductive layer 11 may be the same. In this way, pollution caused by introduction of another element oxide can be avoided, and a natural good interface can be provided between the first passivation part 2 and the first conductive layer 11 at the same layer as the first passivation part 2, so that a good transition can be formed between the first passivation part 2 and the first conductive layer 11 at the same layer as the first passivation part 2, and further the first passivation part 2 and the first conductive layer 11 at the same layer as the first passivation part 2 can be in good contact and better combination.

In some examples, as shown in FIG. 9 to FIG. 13, the memory 100 further includes a functional layer 3, a first passivation layer 4, and a second conductive layer 5 that are disposed in the first hole K1. The functional layer 3, the first passivation layer 4, and the second conductive layer 5 are sequentially arranged along a radial direction of the first hole K1 and along a direction from a side wall of the first hole K1 to an axis of the first hole K1.

A material of the second conductive layer 5 includes a conductive material, for example, may include at least one of conductive materials such as tungsten, titanium nitride, titanium, tantalum nitride, tantalum, copper, silver, hafnium nitride, nickel, ruthenium, iridium, molybdenum, aluminum, magnesium, zinc, zirconium, or doped silicon or polycrystalline silicon. Materials of second conductive layers 5 located in different first holes K1 may be the same or may be different. In addition, materials of the first conductive layer 11 and the second conductive layer 5 may be the same or may be different.

A material of the first passivation layer 4 includes an insulation material, for example, may include silicon oxide, titanium dioxide, zirconium oxide, or aluminum oxide.

For example, the second conductive layer 5 is in a column shape, and both the functional layer 3 and the first passivation layer 4 are in hollow column shapes. The first passivation layer 4 may be sleeved on the second conductive layer 5, the functional layer 3 may be sleeved on the first passivation layer 4, and the functional layer 3 may be in contact with the side wall of the first hole K1.

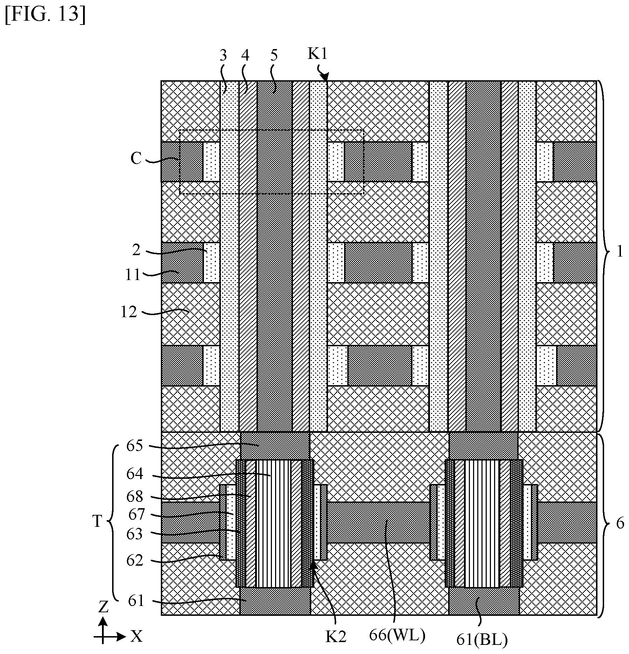

As shown in FIG. 11 and FIG. 13, a part that is of each first conductive layer 11 and that encircles the first hole K1, the first passivation part 2, a part that is of the functional layer 3 and that is opposite to the first conductive layer 11, a part that is of the first passivation layer 4 and that is opposite to the first conductive layer 11, and a part that is of the second conductive layer 5 and that is opposite to the first conductive layer 11 may form a part of the memory cell. For example, the functional layer 3 is configured to store data information, and the second conductive layer 5 may be used as a shared electrode.

The first passivation layer 4 may isolate the functional layer 3 from the second conductive layer 5. In this way, a case in which a defect is formed in the functional layer 3 because the second conductive layer 5 captures an element (for example, oxygen) from the functional layer 3 can be avoided, and a case in which performance of the functional layer 3 is affected because a metal element in the second conductive layer 5 penetrates into the functional layer 3 can be avoided.

It may be understood that, while separating the first hole K1 from the first conductive layer 11, the first passivation part 2 further isolates the first conductive layer 11 from the functional layer 3. In this way, a case in which a defect is formed in the functional layer 3 because the first conductive layer 11 captures an element (for example, oxygen) from the functional layer 3 can be avoided, and a case in which performance of the functional layer 3 is affected because a metal element in the first conductive layer 11 penetrates into the functional layer 3 can be avoided. The plurality of first passivation parts 2 that encircle the same first hole K1 may isolate the functional layer 3 from a plurality of first conductive layers 11. In this way, a case in which a defect is formed in the functional layer 3 because each first conductive layer 11 captures an element (for example, oxygen) from the functional layer 3 can be avoided, and a case in which performance of the functional layer 3 is affected because a metal element in each first conductive layer 11 penetrates into the functional layer 3 can be avoided.

In other words, in this application, a structure of the passivation layer P1 in the foregoing implementation is improved. In this application, the passivation layer P1 that is continuously and vertically formed on the side wall of the deep groove structure in the foregoing implementation is divided, a plurality of mutually independent first passivation parts 2 are disposed, and each first passivation part 2 is selectively disposed at a front end of each first conductive layer 11 that encircles the first hole K1, and selectively and independently isolates a part that is of each first conductive layer 11 and that encircles the first hole K1 from the functional layer 3 located in the first hole K1. In this way, the passivation layer P1 in the foregoing implementation may be prevented from being disposed in the first hole K1, and further a defect caused by low thickness uniformity of the passivation layer P1 may be avoided.

Therefore, in the memory 100 provided in embodiments of this application, the first passivation part 2 that is at the same layer as each first conductive layer 11 and that is mutually independent of another first passivation part is disposed at the first conductive layer 11, so that the first passivation part 2 encircles the first hole K1. The functional layer 3, the first passivation layer 4, and the second conductive layer 5 are sequentially disposed in the first hole K1, so that not only the first passivation part 2 can separate the first conductive layer 11 from the functional layer 3, and the first passivation layer 4 can separate the functional layer 3 from the second conductive layer 5, to avoid impact on performance of the functional layer 3, improve electrical performance and endurance of the memory 100, and prolong a service life of the memory 100, but also the first passivation part 2 can separate the first conductive layer 11 at the same layer as the first passivation part 2 from the another first conductive layer 11, to avoid short-circuiting formed between the part that is of the first conductive layer 11 and that encircles the first hole K1 and the part that is of the another first conductive layer 11 and that encircles the first hole K1, and ensure functionality and the yield of the memory 100.

In addition, in embodiments of this application, the plurality of mutually independent first passivation parts 2 are selectively disposed, and the plurality of first passivation parts 2 that encircle the same first hole K1 may be used to replace the passivation layer P1 in the foregoing implementation. Because two adjacent first passivation parts 2 that encircle a same first hole K1 are separated by a second dielectric layer 12 located between the two first passivation parts 2, a problem of short-circuiting, leakage, or mutual interference between different first conductive layers 11 caused by continuous and vertical formation of the passivation layer P1 can be avoided. Because the material of the first passivation part 2 is the oxide of the material of the corresponding first conductive layer 11, there may be a good contact interface between the first passivation part 2 and the first conductive layer 11. Compared with that in the additionally-formed passivation layer P1, this not only enables the first passivation part 2 and the first conductive layer 11 to be well combined at the interface, to avoid poor contact effect between the passivation layer P1 and the side wall of the deep groove structure caused by uneven thicknesses of the passivation layer P1, but also helps improve forming effect of the functional layer 3, the first passivation layer 4, and the second conductive layer 5 that are subsequently formed in the first hole K1. This helps improve yields of the memory 100 and the electronic device 1000 to which the memory 100 is applied.

In some examples, along the radial direction of the first hole K1, a size range of the first passivation part 2 is but is not limited to 0.5 nm to 2 nm. In this way, isolation effect of the first passivation part 2 on the first conductive layer 11 that is at the same layer as the first passivation part 2 and the functional layer 3 can be ensured, to avoid impact on performance of the functional layer 3, and a good electric field between the first conductive layer 11 and the second conductive layer 5 can be ensured to be formed, to avoid impact on data storage of the functional layer 3.

For example, along the radial direction of the first hole K1, a size of the first passivation part 2 is 0.5 nm, 0.8 nm, 1 nm, 1.4 nm, 1.7 nm, 2 nm, or the like, and sizes of different first passivation parts 2 may be the same or may be different.

It may be understood that the foregoing functional layer 3 includes a plurality of types, and may be specifically selected and set based on an actual requirement. A type of the memory 100 corresponds to the type of the functional layer 3.

In some embodiments, the functional layer 3 includes a ferroelectric thin film, a resistive thin film, or a charge trapping layer. Certainly, the type of the functional layer 3 is not limited thereto.

In some examples, when the functional layer 3 includes the ferroelectric thin film, the type of the memory 100 may be a 3D FeRAM.

For example, the 3D FeRAM may be a HfO₂-based ferroelectric memory. A material of the functional layer 3 includes but is not limited to HZO (hafnium zirconium oxide, hafnium zirconium oxide), La doped HZO, Y doped HZO, Sr doped HZO, Gd doped HZO, Gd/La co-doped HZO, Si doped HfO₂, Al doped HfO, La doped HfO₂, Y doped HfO₂, Gd doped HfO₂, Sr doped HfO₂, and the like.

In some examples, when the functional layer 3 includes the resistive thin film, the type of the memory 100 may be a 3D RRAM.

For example, a material of the functional layer 3 includes but is not limited to NiOₓ, TaOₓ, TiOₓ, HfOₓ, WOₓ, ZrOₓ, Al_{y}Oₓ, SrTiOₓ, and the like.

In some examples, when the functional layer 3 includes the charge trapping layer, the type of the memory 100 may be a 3D NAND.

For example, a material of the functional layer 3 includes but is not limited to silicon nitride.

In some examples, a thickness range of the functional layer 3 may be but is not limited to 1 nm to 100 nm.

For example, the memory 100 is the 3D FeRAM. In this case, as shown in FIG. 11 and FIG. 13, each first conductive layer 11 may be used as a lower electrode, and the second conductive layer 5 may be used as an upper electrode. The part that is of each first conductive layer 11 and that encircles the first hole K1, the first passivation part 2, the part that is of the functional layer 3 and that is opposite to the first conductive layer 11, the part that is of the first passivation layer 4 and that is opposite to the first conductive layer 11, and the part that is of the second conductive layer 5 and that is opposite to the first conductive layer 11 may form a ferroelectric capacitor C, where the ferroelectric capacitor C has an MOFOM structure. The plurality of first conductive layers 11, the plurality of first passivation parts 2, the functional layer 3, the first passivation layer 4, and the second conductive layer 5 that encircle the same first hole K1 may form a plurality of ferroelectric capacitors Cs that are sequentially vertically disposed, and the second conductive layer 5 may be used as an upper electrode shared by the plurality of ferroelectric capacitors Cs. In addition, a same first conductive layer 11 may be used as a lower electrode shared by a plurality of different ferroelectric capacitors Cs located on a same plane.

The foregoing ferroelectric capacitor C of the MOFOM structure can effectively protect an interface of the functional layer 3 (that is, a ferroelectric thin film). In this way, a case in which polarization switching cannot be performed due to generation of a dead layer is avoided, electrical performance and endurance of the memory 100 are improved, and a service life of the memory 100 is prolonged.

It may be understood that in different types of memories 100, materials of the second conductive layer 5 may be the same or different.

In some examples, the memory 100 includes the 3D FeRAM or the 3D RRAM. Correspondingly, the functional layer 3 includes the ferroelectric thin film or the resistive thin film. In this case, the material of the second conductive layer 5 includes a metal material. Optionally, the material of the second conductive layer 5 may also be a non-metallic material. Specifically, for the material of the second conductive layer 5, refer to the foregoing description. Details are not described herein again.

In some other examples, the memory 100 includes the 3D NAND. Correspondingly, the functional layer 3 includes the charge trapping layer. In this case, the second conductive layer 5 includes a semiconductor material. The semiconductor material includes, for example, doped polycrystalline silicon.

It should be noted that, when the memory 100 includes the 3D NAND, the first passivation part 2 may be, for example, referred to as a blocking layer, the first passivation layer 4 may be, for example, referred to as a tunneling layer, and both materials of the first passivation part 2 and the first passivation layer 4 include, for example, silicon oxide.

In some embodiments, as shown in FIG. 9 and FIG. 11 to FIG. 13, the memory 100 further includes a second laminated structure 6 that is stacked with the first laminated structure 1. For example, the second laminated structure 6 is disposed on one side of the first laminated structure 1.

In some examples, as shown in FIG. 9 and FIG. 11 to FIG. 13, the second laminated structure 6 includes a first conductive block 61 disposed on one side of the first laminated structure 1.

For example, there are a plurality of first conductive blocks 61. A shape of the first conductive block 61 includes but is not limited to a block shape or a bar shape. For example, the first conductive block 61 is in the bar shape. As shown in FIG. 9 and FIG. 12, the plurality of first conductive blocks 61 may be disposed in parallel and extend along a second direction Y

A material of the first conductive block 61 is a conductive material, for example, a metal material. Optionally, the material of the first conductive block 61 may include at least one of conductive materials such as titanium, gold, tungsten, molybdenum, indium tin oxide, aluminum, copper, ruthenium, or silver.

In some examples, as shown in FIG. 9 and FIG. 11 to FIG. 13, the second laminated structure 6 further includes a second conductive block 62 disposed between the first conductive block 61 and the first laminated structure 1. The second conductive block 62 has a second hole K2.

For example, a shape of the second conductive block 62 includes but is not limited to a block shape. There are a plurality of second conductive blocks 62, and each second conductive block 62 has one second hole K2. The quantity of second conductive blocks 62 is, for example, the same as the quantity of first holes K1 in the first laminated structure 1.

For example, each second conductive block 62 corresponds to one first conductive block 61. Optionally, when the first conductive block 61 is in the bar shape, each first conductive block 61 may correspond to a plurality of second conductive blocks 62. For example, the second hole K2 in each second conductive block 62 exposes a part of a surface of the first conductive block 61.

A material of the second conductive block 62 includes a conductive material, for example, may include at least one of conductive materials such as tungsten, titanium nitride, titanium, tantalum nitride, tantalum, copper, silver, hafnium nitride, nickel, ruthenium, iridium, molybdenum, or doped silicon or polycrystalline silicon.

In some examples, as shown in FIG. 9 and FIG. 11 to FIG. 13, the second laminated structure 6 further includes a first dielectric layer 63 and a semiconductor layer 64 that are disposed in the second hole K2. The first dielectric layer 63 and the semiconductor layer 64 are sequentially arranged along a radial direction of the second hole K2 and along a direction from a side wall of the second hole K2 to an axis of the second hole K2. The semiconductor layer 64 is in contact with the first conductive block 61.

For example, the first dielectric layer 63 is in a hollow column shape, the semiconductor layer 64 is in a column shape, and the first dielectric layer 63 is sleeved on the semiconductor layer 64. The semiconductor layer 64 may be in contact with the exposed part of the surface surface of the first conductive block 61 through the second hole K2, so that the semiconductor layer 64 is electrically connected to the first conductive block 61.

A material of the first dielectric layer 63 may include at least one of insulation materials such as silicon dioxide, aluminum oxide, hafnium dioxide, zirconium oxide, titanium dioxide, yttrium oxide, and silicon nitride.

A material of the semiconductor layer 64 may include at least one of semiconductor materials such as silicon, polycrystalline silicon, and amorphous silicon.

In some examples, as shown in FIG. 9 and FIG. 11 to FIG. 13, the second laminated structure 6 further includes a third conductive block 65 disposed between the second conductive block 62 and the first laminated structure 1.

For example, a shape of the third conductive block 65 includes but is not limited to a block shape. There are a plurality of third conductive blocks 65, and the quantity of third conductive blocks 65 is, for example, the same as the quantity of the second conductive blocks 62.

For example, each third conductive block 65 is in contact with one semiconductor layer 64 and one second conductive layer 5. In other words, each third conductive block 65 may be electrically connected to a corresponding semiconductor layer 64 and a corresponding second conductive layer 5.

A material of the third conductive block 65 is a conductive material, for example, a metal material. Optionally, the material of the third conductive block 65 may include at least one of conductive materials such as titanium, gold, tungsten, molybdenum, indium tin oxide, aluminum, copper, ruthenium, or silver.

It may be understood that a second conductive block 62, a first dielectric layer 63 and a semiconductor layer 64 that are located in a second hole K2 of the second conductive block 62, a third conductive block 65 electrically connected to the semiconductor layer 64, and a part that is of the first conductive block 61 and that is electrically connected to the semiconductor layer 64 may form a transistor T. The second conductive block 62 may be used as a gate of the transistor T, and the first dielectric layer 63 may be used as a gate dielectric layer of the transistor T, the semiconductor layer 64 may be used as an active layer of the transistor T, the third conductive block 65 may be used as one of a source and a drain of the transistor T, and the part that is of the first conductive block 61 and that is electrically connected to the semiconductor layer 64 may be used as the other of the source and the drain of the transistor T. The transistor T, a second conductive layer 5 electrically connected to the transistor T, a first passivation layer 4, a functional layer 3, and a first passivation part 2 that correspond to the second conductive layer 5, and a first conductive layer 11 may form a memory cell.

Film layers in the second laminated structure 6 may form a plurality of transistors T. For example, a quantity of the plurality of transistors T is the same as the quantity of first holes K1 in the first laminated structure 1. The transistors T are electrically connected to second conductive layers 5 in the first holes K1 in a one-to-one correspondence, and transmit required voltages for the corresponding second conductive layers 5. For another example, a quantity of the plurality of transistors T is greater than the quantity of first holes K1 in the first laminated structure 1, some transistors T in the plurality of transistors T are electrically connected to second conductive layers 5 in the first holes K1 in a one-to-one correspondence, and provide required voltages for the corresponding second conductive layers 5. The other transistors T in the plurality of transistors T may form a control circuit.

In some examples, as shown in FIG. 9 and FIG. 12, when the first conductive block 61 is in the bar shape, the first conductive block 61 may not only be used as an electrode shared by a same column of transistors T, but also may be used as a bit line BL to transmit required voltages to a column of transistors T electrically connected to the first conductive block 61.

In some examples, as shown in FIG. 9 and FIG. 11 to FIG. 13, the second laminated structure 6 further includes a plurality of fourth conductive blocks 66. A shape of the fourth conductive block 66 includes but is not limited to a bar shape. For example, the fourth conductive block 66 is in the bar shape. As shown in FIG. 9 and FIG. 12, the plurality of fourth conductive blocks 66 may be disposed in parallel and extend along a first direction X. Each fourth conductive block 66 may be electrically connected to a gate (that is, the second conductive block 62) of a same row of transistors T, and serve as a word line WL to transmit required voltages to a row of transistors T electrically connected to the fourth conductive block 66.

It may be understood that, the transistor T may be a gate-all-around field-effect transistor (Gate-All-Around Field-Effect Transistor, GAA FET). Certainly, the transistor T may also be a channel-all-around field-effect transistor (Channel-All-Around Field-Effect Transistor, CAA FET) or a vertical planar channel transistor. Correspondingly, the film layer included in the second laminated structure 6 may be correspondingly changed.

In some embodiments, as shown in FIG. 12 and FIG. 13, when the transistor T is the GAA FET, the second laminated structure 6 further includes a second passivation part 67 and a second passivation layer 68. The second passivation part 67 is disposed between the first dielectric layer 63 and the second conductive block 62, and the second passivation layer 68 is disposed between the first dielectric layer 63 and the semiconductor layer 64.

The second passivation part 67 may separate the first dielectric layer 63 from the second conductive block 62, to avoid generation of element penetration or capturing between the first dielectric layer 63 and the second conductive block 62, thereby avoiding impact on performance of the first dielectric layer 63 and the second conductive block 62. The second passivation layer 68 may separate the first dielectric layer 63 from the semiconductor layer 64, to avoid element penetration or capturing between the first dielectric layer 63 and the semiconductor layer 64, thereby avoiding impact on performance of the first dielectric layer 63 and the semiconductor layer 64.

In some examples, the second passivation part 67 and the second conductive block 62 are at a same layer, and a material of the second passivation part 67 is oxide of the material of the second conductive block 62.

For example, the material of the second passivation part 67 includes at least one of tungsten oxide, titanium oxynitride, titanium oxide, tantalum oxide, silicon oxide, copper oxide, silver oxide, hafnium oxide, nickel oxide, ruthenium oxide, iridium oxide, aluminum oxide, magnesium oxide, zinc oxide, and zirconium oxide.

If the material of the second conductive block 62 is tungsten, the material of the second passivation part 67 at the same layer as the second conductive block 62 is tungsten oxide; or if the material of the second conductive block 62 is titanium nitride, the material of the second passivation part 67 at the same layer as the second conductive block 62 is titanium oxynitride; or if the material of the second conductive block 62 is titanium, the material of the second passivation part 67 at the same layer as the second conductive block 62 is titanium oxide; or if the material of the second conductive block 62 is tantalum nitride, the material of the second passivation part 67 that is at the same layer as the second conductive block 62 is tantalum oxynitride; or if the material of the second conductive block 62 is tantalum, the material of the second passivation part 67 at the same layer as the second conductive block 62 is tantalum oxide; or if the material of the second conductive block 62 is copper, the material of the second passivation part 67 at the same layer as the second conductive block 62 is copper oxide; or if the material of the second conductive block 62 is silver, the material of the second passivation part 67 at the same layer as the second conductive block 62 is silver oxide; or if the material of the second conductive block 62 is hafnium nitride, the material of the second passivation part 67 at the same layer as the second conductive block 62 is hafnium oxide; or if the material of the second conductive block 62 is nickel, the material of the second passivation part 67 at the same layer as the second conductive block 62 is nickel oxide; or if the material of the second conductive block 62 is ruthenium, the material of the second passivation part 67 at the same layer as the second conductive block 62 is ruthenium oxide; or if the material of the second conductive block 62 is iridium, the material of the second passivation part 67 at the same layer as the second conductive block 62 is iridium oxide; or if the material of the second conductive block 62 is molybdenum, the material of the second passivation part 67 at the same layer as the second conductive block 62 is molybdenum oxide; or if the material of the second conductive block 62 is aluminum, the material of the second passivation part 67 at the same layer as the second conductive block 62 is aluminum oxide; or if the material of the second conductive block 62 is magnesium, the material of the second passivation part 67 at the same layer as the second conductive block 62 is magnesium oxide; or if the material of the second conductive block 62 is zinc, the material of the second passivation part 67 at the same layer as the second conductive block 62 is zinc oxide; or if the material of the second conductive block 62 is zirconium, the material of the second passivation part 67 at the same layer as the second conductive block 62 is zirconium oxide; or if the material of the second conductive block 62 is doped silicon or polycrystalline silicon, the material of the second passivation part 67 at the same layer as the second conductive block 62 is silicon oxide.

The second passivation part 67 and the second conductive block 62 are disposed at the same layer, to avoid the second passivation part 67 from being formed separately in the second hole K2, thereby avoiding uneven thicknesses of the second passivation part 67. In addition, because the material of the second passivation part 67 is the oxide of the material of the second conductive block 62, a good contact interface may exist between the second passivation part 67 and the second conductive block 62. This helps improve forming effect of the first dielectric layer 63, the second passivation layer 68, and the semiconductor layer 64 that are subsequently formed, and improve yields of the transistor T and the memory 100.

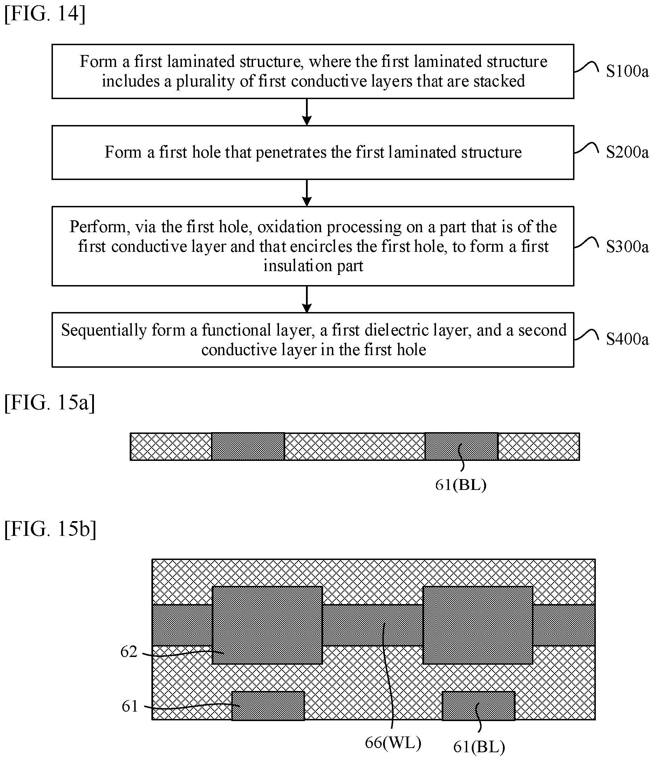

Some embodiments of this application provide a preparation method for a memory. The preparation method may be, for example, used to prepare the foregoing memory 100. As shown in FIG. 14, the preparation method includes S100a to S400a.

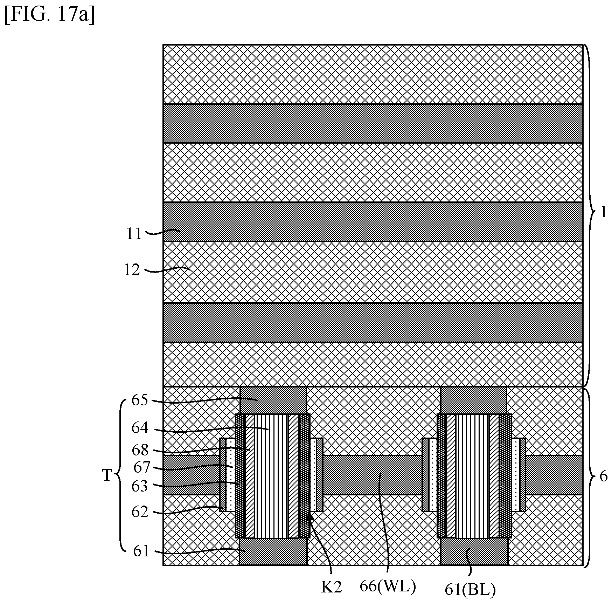

S100a: Form a first laminated structure 1, as shown in FIG. 17a. The first laminated structure 1 includes a plurality of first conductive layers 11 that are stacked.

For example, the first laminated structure 1 may further include a second dielectric layer 12 disposed between two adjacent first conductive layers 11. In other words, in the first laminated structure 1, the first conductive layer 11 and the second dielectric layer 12 may be alternately stacked.

For example, a process of forming the first laminated structure 1 includes: depositing and forming the second dielectric layer 12 by using thin film deposition processes such as chemical vapor deposition (chemical vapor deposition, CVD), physical vapor deposition (physical vapor deposition, PVD), atomic layer deposition (atomic layer deposition, ALD), or any combination thereof; forming the first conductive layer 11 on the second dielectric layer 12 by using thin film deposition processes such as CVD, PVD, ALD, or any combination thereof; and then repeating the foregoing steps to alternately form the plurality of first conductive layers 11 and a plurality of second dielectric layers 12.

For materials of the first conductive layer 11 and the second dielectric layer 12, refer to the foregoing description. Details are not described herein again.

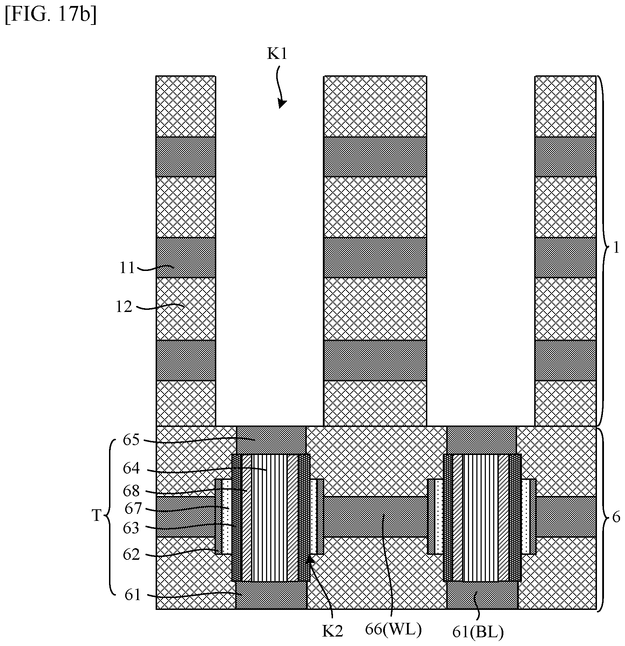

S200a: Form a first hole K1 that penetrates the first laminated structure 1, as shown in FIG. 17b.

For example, in this application, the first laminated structure 1 may be etched by using a photolithography process and a dry etching process (for example, having a high-depth-width ratio), to form the first hole K1.

For example, in this application, a hard mask may be formed on the first laminated structure 1 by using the photolithography process, and then the first laminated structure 1 is etched based on the hard mask and by using the dry etching process, to form the first hole K1 that penetrates the first conductive layers 11 and the second dielectric layers 12 in the first laminated structure 1.

For example, there are a plurality of first holes K1, and the plurality of first holes K1 may be arranged in an array.

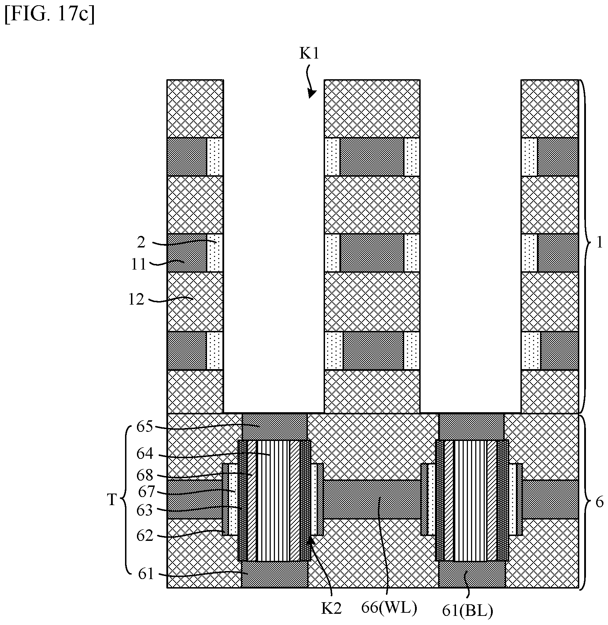

S300a: Perform, via the first hole K1, oxidation processing on a part that is of the first conductive layer 11 and that encircles the first hole K1, to form a first passivation part 2, as shown in FIG. 17c.

For example, in this application, oxidation processing may be performed on the part that is of the first conductive layer 11 and that encircles the first hole K1 by using a thermal oxidation process, a dry oxygen oxidation process, a wet oxygen oxidation process, an oxygen plasma (O₂ Plasma) processing process, an ozone plasma (O₃ Plasma) processing process, an ion implantation process, an anodic oxidation process, or another oxidation process. Oxide obtained after a material of the part that is of the first conductive layer 11 and that encircles the first hole K1 is oxidized may form the first passivation part 2.

For example, a size of the obtained first passivation part 2 along a radial direction of the first hole K1 may be controlled by controlling time of oxidation processing. In this application, oxidation processing is synchronously performed on the plurality of first conductive layers 11 through the first hole K1. Therefore, sizes of different first passivation parts 2 obtained through oxidation are uniform along the radial direction of the first hole K1.

Because there are a plurality of first conductive layers 11 and a plurality of first holes K1, there are a plurality of formed first passivation parts 2, and the plurality of first passivation parts 2 are independent of each other.

Herein, the part that is of the first conductive layer 11 and that encircles the first hole K1 may also be referred to as a tip area that is of the first conductive layer 11 and that is used for being in contact with a functional layer 3 formed later. In this application, the first passivation part 2 is selectively disposed in the tip area.

It may be understood that the material of the first conductive layer 11 matches a material of the first passivation part 2 obtained after the first conductive layer 11 is oxidized.

For example, if the material of the first conductive layer 11 is tungsten, the material of the obtained first passivation part 2 is tungsten oxide; or if the material of the first conductive layer 11 is titanium nitride, the material of the obtained first passivation part 2 is titanium oxynitride; or if the material of the first conductive layer 11 is titanium, the material of the obtained first passivation part 2 is titanium oxide; or if the material of the first conductive layer 11 is tantalum nitride, the material of the obtained first passivation part 2 is tantalum oxynitride; or if the material of the first conductive layer 11 is tantalum, the material of the obtained first passivation part 2 is tantalum oxide; or if the material of the first conductive layer 11 is copper, the material of the obtained first passivation part 2 is copper oxide; or if the material of the first conductive layer 11 is silver, the material of the obtained first passivation part 2 is silver oxide; or if the material of the first conductive layer 11 is hafnium nitride, the material of the obtained first passivation part 2 is hafnium oxide; or if the material of the first conductive layer 11 is nickel, the material of the obtained first passivation part 2 is nickel oxide; or if the material of the first conductive layer 11 is ruthenium, the material of the obtained first passivation part 2 is ruthenium oxide; or if the material of the first conductive layer 11 is iridium, the material of the obtained first passivation part 2 is iridium oxide; or if the material of the first conductive layer 11 is molybdenum, the material of the obtained first passivation part 2 is molybdenum oxide; or if the material of the first conductive layer 11 is aluminum, the material of the obtained first passivation part 2 is aluminum oxide; or if the material of the first conductive layer 11 is magnesium, the material of the obtained first passivation part 2 is magnesium oxide; or if the material of the first conductive layer 11 is zinc, the material of the obtained first passivation part 2 is zinc oxide; or if the material of the first conductive layer 11 is zirconium, the material of the obtained first passivation part 2 is zirconium oxide; or if the material of the first conductive layer 11 is doped silicon or polycrystalline silicon, the material of the obtained first passivation part 2 is silicon oxide.

Because the first conductive layer 11 is of an integrated structure, and the first passivation part 2 is obtained after the part that is of the first conductive layer 11 and that encircles the first hole K1 is oxidized, the first conductive layer 11 and the first passivation part 2 are of an integrated structure, are not separated from each other, and can naturally form a good transition between the first conductive layer 11 and the first passivation part 2. In this way, the first passivation part 2 and the first conductive layer 11 can be better combined.

In this case, a surface that is of the first passivation part 2 and that encircles the first hole K1 and a surface that is of the second dielectric layer 12 and that encircles the first hole K1 form a side wall of the first hole K1, and the side wall of the first hole K1 is flat.

In this application, a method for preparing and forming the first passivation part 2 is simple. The first passivation part 2 can be introduced and a flat side wall can be obtained without a need to deposit an insulation material on the side wall of the first hole K1 by using a deposition process with a high difficulty. The first passivation part 2 may be referred to as a self-aligned passivation part. The side wall of the first hole K1 may be referred to as a self-aligned interface, and the self-aligned interface is neat or flat.

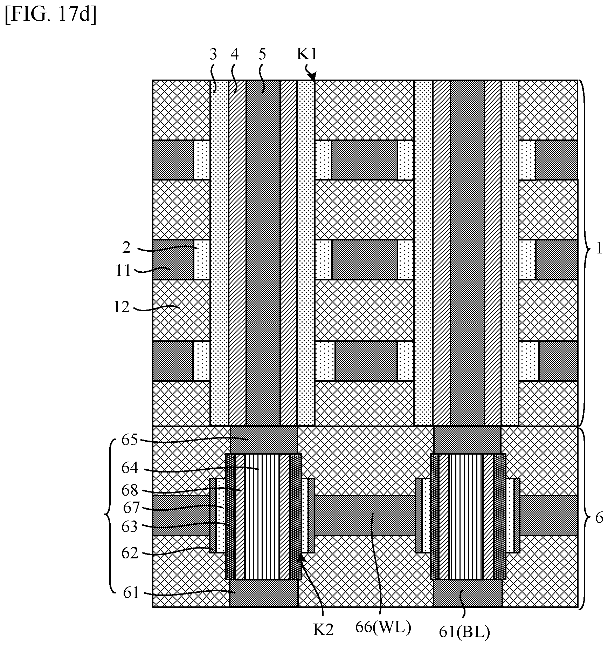

S400a: Sequentially form the functional layer 3, a first passivation layer 4, and a second conductive layer 5 in the first hole K1, as shown in FIG. 17d.

For example, in this application, the functional layer 3, the first passivation layer 4, or the second conductive layer 5 may be formed in the first hole K1 by using thin film deposition processes such as CVD, PVD, ALD, or any combination thereof.

The first passivation part 2 may isolate the first conductive layer 11 from the functional layer 3. In this way, a case in which a defect is formed in the functional layer 3 because the first conductive layer 11 captures an element (for example, oxygen) from the functional layer 3 can be avoided, and a case in which performance of the functional layer 3 is affected because a metal element in the first conductive layer 11 penetrates into the functional layer 3 can be avoided. The first passivation layer 4 may isolate the functional layer 3 from the second conductive layer 5. In this way, a case in which a defect is formed in the functional layer 3 because the second conductive layer 5 captures an element (for example, oxygen) from the functional layer 3 can be avoided, and a case in which performance of the functional layer 3 is affected because a metal element in the second conductive layer 5 penetrates into the functional layer 3 can be avoided. In this way, generation of a dead layer and penetration of an isolated element can be avoided, electrical performance and endurance of the prepared memory 100 can be improved, and a service life of the prepared memory 100 can be prolonged.

It may be understood that, in this application, a plurality of first passivation parts 2 that encircles a same first hole K1 are equivalent to the passivation layer P1 in the foregoing implementation. Therefore, a plurality of self-aligned passivation parts may also be referred to as a self-aligned passivation layer.

It can be learned from the foregoing that, in this application, oxidation processing is performed on parts that are of the first conductive layers 11 and that encircle the first hole K1, so that the plurality of mutually independent first passivation parts 2 may be selectively formed in tip areas that are of the first conductive layers 11 and that encircle the first hole K1. In this application, the first passivation part 2 may be used to replace the passivation layer P1 in the foregoing implementation. Because the first passivation part 2 in this application is obtained through oxidation processing on the first conductive layer 11, and different first passivation parts 2 are independent of each other and discontinuous, the first passivation part 2 in this application is at a same layer as the corresponding first conductive layer 11, and the different first passivation parts 2 are separated by the second dielectric layer 12. Sizes of the different first passivation parts 2 are uniform along the radial direction of the first hole K1, instead of continuously covering the side wall of the first hole K1. This can avoid a problem caused by introduction of the vertical continuous passivation layer P1, for example, avoid leakage between the different first conductive layers 11 and interference caused by leakage caused by introduction of the vertical continuous passivation layer P1.

In addition, in this application, the first passivation part 2 is used to replace the passivation layer P1 in the foregoing implementation, so that not only introduction of the passivation layer P1 can be avoided, and pollution caused by introduction of another element oxide can be avoided, but also good contact between the first passivation part 2 and the first conductive layer 11 can be ensured, thereby avoiding a problem that the first passivation part 2 is difficult to be in good contact with the first conductive layer 11 because the passivation layer P1 is uneven in thickness.

In addition, this application can provide the flat self-aligned interface. Therefore, compared with that in the passivation layer P1 introduced in the foregoing implementation, control on thickness uniformity, flatness, and retention of the passivation layer P1 can be omitted. This not only can simplify the preparation method for a memory, and reduce a difficulty in preparing the memory, but also can improve yields of the functional layer 3, the first passivation layer 4, and the second conductive layer 5 that are subsequently deposited and formed in the first hole K1, and further improve a yield of the prepared memory 100.

In some embodiments, before S100a, that is, before the first laminated structure 1 is formed, the preparation method further includes S010a to S050a.

S010a: Form a first conductive block 61, as shown in FIG. 15a.

For example, in this application, a conductive thin film may be formed by using thin film deposition processes such as CVD, PVD, ALD, or any combination thereof, and then the conductive thin film is etched by using a photolithography process or another etching process, to form a plurality of first conductive blocks 61.

For another example, a process of forming the first conductive block includes: forming a first dielectric thin film, and then forming a plurality of grooves on the first dielectric thin film, where shapes and an arrangement manner of the plurality of grooves are the same as those of to-be-formed first conductive blocks; and then forming the first conductive block 61 in the groove by using thin film deposition processes such as CVD, PVD, ALD, or any combination thereof.

For a shape and a material of the first conductive block 61, refer to the foregoing description. Details are not described herein again.

S020a: Form a second conductive block 62 on the first conductive block 61, as shown in FIG. 15b.

For example, before the second conductive block 62 is formed, the fourth conductive block 66 may be first formed. A process of forming the fourth conductive block 66 is basically the same as the process of forming the first conductive block 61 in S010a. Details are not described herein again.

For example, after the fourth conductive block 66 is formed, the fourth conductive block 66 may be etched by using a photolithography process or another etching process, to form a groove, and then the second conductive block 62 may be formed in the groove. The second conductive block 62 is in direct contact with the fourth conductive block 66 to form an electrical connection, and the second conductive block 62 and the first conductive block 61 has a gap and are not in direct contact.

For a shape and a material of the second conductive block 62 and a shape and a material of the fourth conductive block 66, refer to the foregoing descriptions. Details are not described herein again.

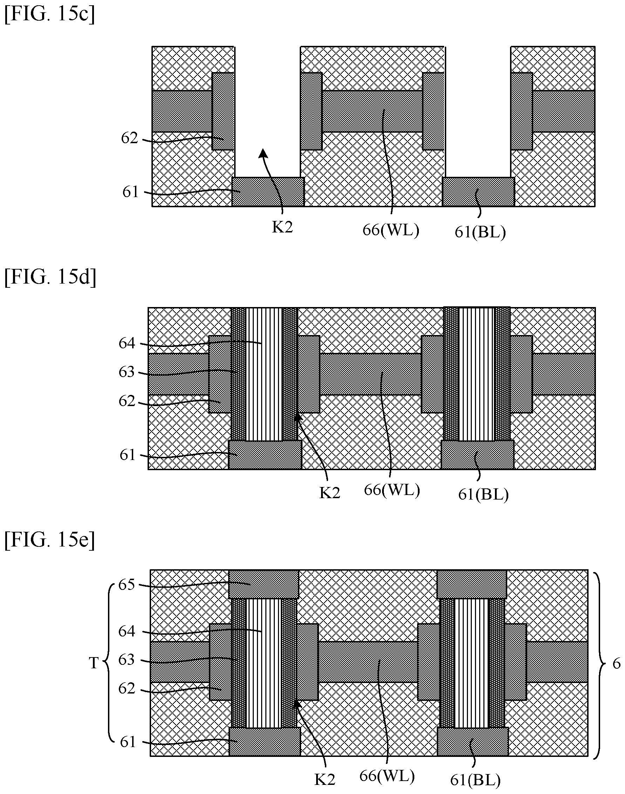

S030a: Form a second hole K2 that penetrates the second conductive block 62, as shown in FIG. 15c. The second hole K2 exposes a part of the first conductive block 61.

For example, in this application, the second hole K2 that penetrates the second conductive block 62 may be formed by using a photolithography process, a dry etching process, another etching process, or the like. Second holes K2 and second conductive blocks 62 are disposed, for example, in a one-to-one correspondence.

S040a: Sequentially form a first dielectric layer 63 and a semiconductor layer 64 in the second hole K2, as shown in FIG. 15d.

For example, in this application, the first dielectric layer 63 and the semiconductor layer 64 may be sequentially formed in the second hole K2 by using thin film deposition processes such as CVD, PVD, ALD, or any combination thereof.

For a shape and a material of the first dielectric layer 63 and a shape and a material of the semiconductor layer 64, refer to the foregoing descriptions. Details are not described herein again.

S050a: Form a third conductive block 65 on the first dielectric layer 63 and the semiconductor layer 64, as shown in FIG. 15e. The third conductive block 65 is in contact with the semiconductor layer 64.

For example, a process of forming the third conductive block 65 is basically the same as the process of forming the first conductive block 61 in S010a. Details are not described herein again.

It should be noted that, after the third conductive block 65 is formed, the first laminated structure 1 may be formed on the third conductive block 65, and the third conductive block 65 may be in contact with the second conductive layer 5.

It may be understood that a second conductive block 62, a first dielectric layer 63 and a semiconductor layer 64 that are located in a second hole K2 of the second conductive block 62, a third conductive block 65 electrically connected to the semiconductor layer 64, and a part that is of the first conductive block 61 and that is electrically connected to the semiconductor layer 64 may form a transistor T. The second conductive block 62 may be used as a gate of the transistor T, and the first dielectric layer 63 may be used as a gate dielectric layer of the transistor T, the semiconductor layer 64 may be used as an active layer of the transistor T, the third conductive block 65 may be used as one of a source and a drain of the transistor T, and the part that is of the first conductive block 61 and that is electrically connected to the semiconductor layer 64 may be used as the other of the source and the drain of the transistor T. The transistor T, a second conductive layer 5 electrically connected to the transistor T, a first passivation layer 4, a functional layer 3, and a first passivation part 2 that correspond to the second conductive layer 5, and a first conductive layer 11 may form a memory cell.

It may be understood that, the transistor T may be a gate-all-around field-effect transistor (Gate-All-Around Field-Effect Transistor, GAA FET). Certainly, the transistor T may also be a channel-all-around field-effect transistor (Channel-All-Around Field-Effect Transistor, CAA FET) or a vertical planar channel transistor. Correspondingly, a structure of the foregoing film layer may be correspondingly changed, and a method for preparing the memory may be correspondingly changed.

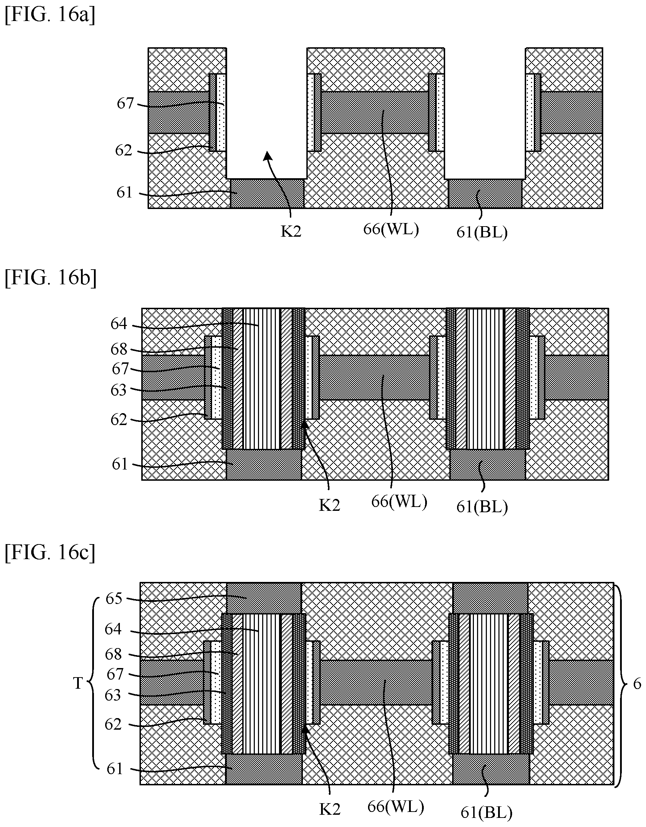

In some embodiments, when the transistor T is the GAA FET, before S040a, that is, before the first dielectric layer 63 and the semiconductor layer 64 are sequentially formed in the second hole K2, as shown in FIG. 15c and FIG. 16a, the preparation method further includes: performing, via the second hole K2, oxidation processing on a part that is of the second conductive block 62 and that encircles the second hole K2, to form a second passivation part 67.

For example, in this application, oxidation processing may be performed on the part that is of the second conductive block 62 and that encircles the second hole K2 by using a thermal oxidation process, a dry oxygen oxidation process, a wet oxygen oxidation process, an oxygen plasma (O₂ Plasma) processing process, an ozone plasma (O₃ Plasma) processing process, an ion implantation process, an anodic oxidation process, or another oxidation process. Oxide obtained after a material of the part that is of the second conductive block 62 and that encircles the second hole K2 is oxidized may form the second passivation part 67.

It may be understood that the material of the second conductive block 62 matches a material of the second passivation part 67 obtained after the second conductive block 62 is oxidized.

For example, if the material of the second conductive block 62 is tungsten, the material of the obtained second passivation part 67 is tungsten oxide; or if the material of the second conductive block 62 is titanium nitride, the material of the obtained second passivation part 67 is titanium oxynitride; or if the material of the second conductive block 62 is titanium, the material of the obtained second passivation part 67 is titanium oxide; or if the material of the second conductive block 62 is tantalum nitride, the material of the obtained second passivation part 67 is tantalum oxynitride; or if the material of the second conductive block 62 is tantalum, the material of the obtained second passivation part 67 is tantalum oxide; or if the material of the second conductive block 62 is copper, the material of the obtained second passivation part 67 is copper oxide; or if the material of the second conductive block 62 is silver, the material of the obtained second passivation part 67 is silver oxide; or if the material of the second conductive block 62 is hafnium nitride, the material of the obtained second passivation part 67 is hafnium oxide; or if the material of the second conductive block 62 is nickel, the material of the obtained second passivation part 67 is nickel oxide; or if the material of the second conductive block 62 is ruthenium, the material of the obtained second passivation part 67 is ruthenium oxide; or if the material of the second conductive block 62 is iridium, the material of the obtained second passivation part 67 is iridium oxide; or if the material of the second conductive block 62 is molybdenum, the material of the obtained second passivation part 67 is molybdenum oxide; or if the material of the second conductive block 62 is aluminum, the material of the obtained second passivation part 67 is aluminum oxide; or if the material of the second conductive block 62 is magnesium, the material of the obtained second passivation part 67 is magnesium oxide; or if the material of the second conductive block 62 is zinc, the material of the obtained second passivation part 67 is zinc oxide; or if the material of the second conductive block 62 is zirconium, the material of the obtained second passivation part 67 is zirconium oxide; or if the material of the second conductive block 62 is doped silicon or polycrystalline silicon, the material of the obtained second passivation part 67 is silicon oxide.

It may be understood that, the second passivation part 67 is formed between the first dielectric layer 63 and the second conductive block 62, and the second passivation part 67 may separate the first dielectric layer 63 from the second conductive block 62, to avoid generation of element penetration or capturing between the first dielectric layer 63 and the second conductive block 62, thereby avoiding impact on performance of the first dielectric layer 63 and the second conductive block 62, and avoiding impact on performance and a service life of the prepared memory 100.

Because the second conductive block 62 is of an integrated structure, and the second passivation part 67 is obtained after the part of the second conductive block 62 and that encircles the second hole K2 is oxidized, the second conductive block 62 and the second passivation part 67 are of an integrated structure, are not separated from each other, and can naturally form a good transition between the second conductive block 62 and the second passivation part 67. In this way, the second conductive block 62 and the second passivation part 67 can be better combined.

In this application, a method for preparing and forming the second passivation part 67 is simple. The second passivation part 67 can be introduced and a flat side wall can be obtained without a need to deposit an insulation material on the side wall of the second hole K2 by using a deposition process with a high difficulty. The side wall is flat. This helps improve a yield of a film layer subsequently formed in the second hole K2, thereby improving a yield of the prepared memory 100.

In some examples, before the semiconductor layer 64 is formed, as shown in FIG. 16b, the foregoing preparation method further includes: forming a second passivation layer 68. As shown in FIG. 16c, after the second passivation layer 68 and the semiconductor layer 64 are formed, the third conductive block 65 may be formed.

For example, in this application, the second passivation layer 68 may be formed by using thin film deposition processes such as CVD, PVD, ALD, or any combination thereof.

It may be understood that, the second passivation layer 68 is formed between the first dielectric layer 63 and the semiconductor layer 64, and the second passivation layer 68 may separate the first dielectric layer 63 from the semiconductor layer 64, to avoid generation of element penetration or capturing between the first dielectric layer 63 and the semiconductor layer 64, thereby avoiding impact on performance of the first dielectric layer 63 and the semiconductor layer 64, and avoiding impact on performance and a service life of the prepared memory 100.

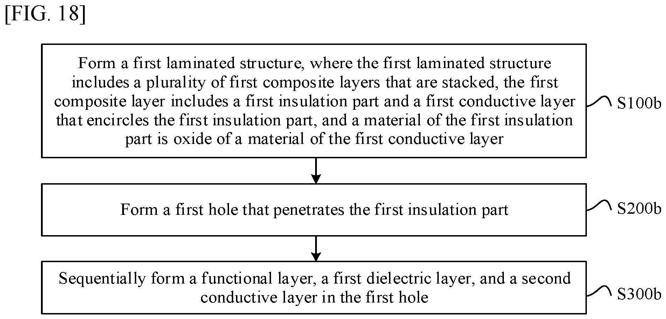

Some embodiments of this application further provide a preparation method for a memory. The preparation method may be, for example, used to prepare the foregoing memory 100. As shown in FIG. 18, the preparation method includes S100b to S300b.

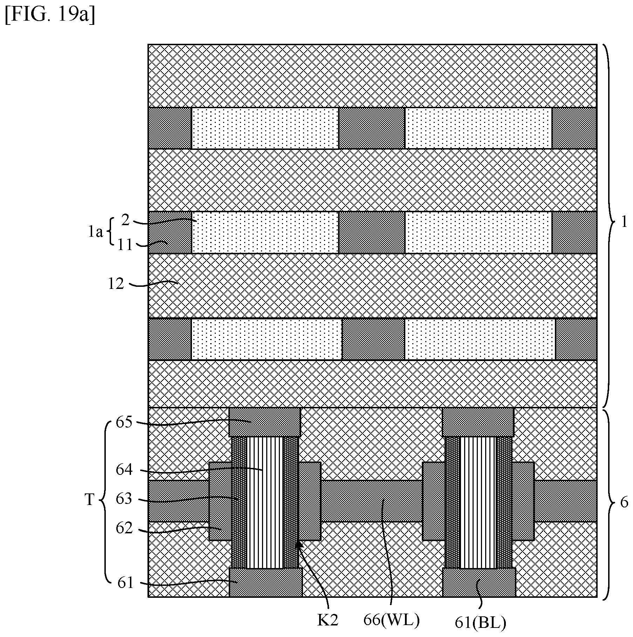

S100b: Form a first laminated structure 1, as shown in FIG. 19a. The first laminated structure 1 includes a plurality of first composite layers 1a that are stacked, the first composite layer 1a includes a first passivation part 2 and a first conductive layer 11 that encircles the first passivation part 2, and a material of the first passivation part 2 is oxide of a material of the first conductive layer 11.

For example, the first laminated structure 1 may further include a second dielectric layer 12 disposed between two adjacent first composite layers 1a. In other words, in the first laminated structure 1, the first composite layer 1a and the second dielectric layer 12 may be alternately stacked.

For example, a process of forming the first laminated structure 1 includes: forming the second dielectric layer 12 by using thin film deposition processes such as CVD, PVD, ALD, or any combination thereof; forming the first composite layer 1a on the second dielectric layer 12; and then repeating the foregoing steps to alternately form the plurality of first composite layers 1a and a plurality of second dielectric layers 12.

For example, each first composite layer 1a may include a plurality of first passivation parts 2, and the plurality of first passivation parts 2 are disposed independently of each other. Disposing positions and an arrangement manner of the first passivation parts 2 are the same as those of to-be-formed first holes K1. For example, the first passivation parts 2 are arranged in an array.

It may be understood that the material of the first conductive layer 11 matches the material of the first passivation part 2.

For example, if the material of the first conductive layer 11 is tungsten, the material of the first passivation part 2 is tungsten oxide; or if the material of the first conductive layer 11 is titanium nitride, the material of the first passivation part 2 is titanium oxynitride; or if the material of the first conductive layer 11 is titanium, the material of the first passivation part 2 is titanium oxide; or if the material of the first conductive layer 11 is tantalum nitride, the material of the first passivation part 2 is tantalum oxynitride; or if the material of the first conductive layer 11 is tantalum, the material of the first passivation part 2 is tantalum oxide; or if the material of the first conductive layer 11 is copper, the material of the first passivation part 2 is copper oxide; or if the material of the first conductive layer 11 is silver, the material of the first passivation part 2 is silver oxide; or if the material of the first conductive layer 11 is hafnium nitride, the material of the first passivation part 2 is hafnium oxide; or if the material of the first conductive layer 11 is nickel, the material of the first passivation part 2 is nickel oxide; or if the material of the first conductive layer 11 is ruthenium, the material of the first passivation part 2 is ruthenium oxide; or if the material of the first conductive layer 11 is iridium, the material of the first passivation part 2 is iridium oxide; or if the material of the first conductive layer 11 is molybdenum, the material of the first passivation part 2 is molybdenum oxide; or if the material of the first conductive layer 11 is aluminum, the material of the first passivation part 2 is aluminum oxide; or if the material of the first conductive layer 11 is magnesium, the material of the first passivation part 2 is magnesium oxide; or if the material of the first conductive layer 11 is zinc, the material of the first passivation part 2 is zinc oxide; or if the material of the first conductive layer 11 is zirconium, the material of the first passivation part 2 is zirconium oxide; or if the material of the first conductive layer 11 is doped silicon or polycrystalline silicon, the material of the first passivation part 2 is silicon oxide.

Because main elements of the materials of the first conductive layer 11 and the first passivation part 2 are the same, not only pollution caused by introduction of another element oxide can be avoided, but also a good interface can be provided between the first conductive layer 11 and the first passivation part 2 at a same layer as the first conductive layer 11, so that the first conductive layer 11 and the first passivation part 2 at the same layer as the first conductive layer 11 can be better combined.

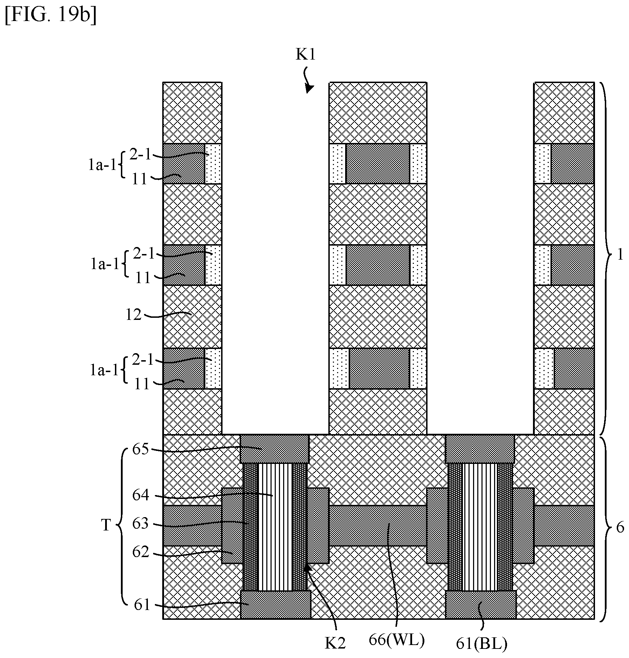

S200b: Form a first hole K1 that penetrates the first passivation part 2, as shown in FIG. 19b.

For example, in this application, the first laminated structure 1 may be etched by using a photolithography process and a dry etching process (for example, having a high-depth-width ratio), to form the first hole K1, and the first hole K1 penetrates the first passivation part 2.

It should be noted that the plurality of first passivation parts 2 in each first composite layer 1a are arranged in a same manner, and are in corresponding positions. In this way, after the first hole K1 is formed, the first hole K1 may penetrate a plurality of first passivation parts 2 that are located at different first composite layers 1a and that are in corresponding positions. In addition, the first hole K1 further penetrates the second dielectric layer 12.

For example, FIG. 19b shows three first composite layers 1a-1, 1a-2, and 1a-3. Positions of a first passivation part 2-1 in the first composite layer 1a-1, a first passivation part 2-2 in the first composite layer 1a-2, and a first passivation part 2-3 in the first composite layer 1a-3 are corresponding. A same first hole K1 penetrates the first passivation parts 2-1, 2-2, and 2-3.

Along a radial direction of the first hole K1, a size of the first passivation part 2 may be set based on an aperture of the first hole K1. For example, along the radial direction of the first hole K1, if a size of the first passivation part 2 after being penetrated is Di, and an aperture of the first hole K1 is D₂, a size of the first passivation part 2 before being penetrated is D₂+2×D₁.

In this application, the first passivation part 2 is etched to form the first hole K1. Therefore, a self-aligned side wall (a side wall corresponding to the first hole K1) may be formed from top to bottom, and the side wall is flat.

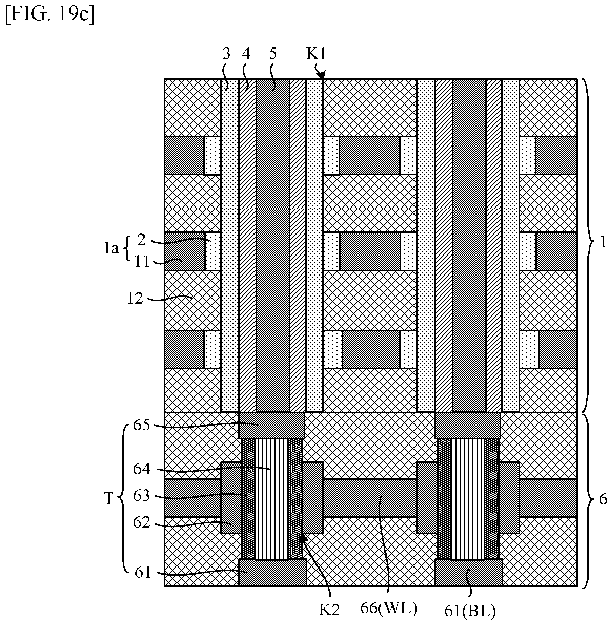

S300b: Sequentially form a functional layer 3, a first passivation layer 4, and a second conductive layer 5 in the first hole K1, as shown in FIG. 19c.

For example, in this application, the functional layer 3, the first passivation layer 4, or the second conductive layer 5 may be formed in the first hole K1 by using thin film deposition processes such as CVD, PVD, ALD, or any combination thereof.

The first passivation part 2 may isolate the first conductive layer 11 from the functional layer 3. In this way, a case in which a defect is formed in the functional layer 3 because the first conductive layer 11 captures an element (for example, oxygen) from the functional layer 3 can be avoided, and a case in which performance of the functional layer 3 is affected because a metal element in the first conductive layer 11 penetrates into the functional layer 3 can be avoided. The first passivation layer 4 may isolate the functional layer 3 from the second conductive layer 5. In this way, a case in which a defect is formed in the functional layer 3 because the second conductive layer 5 captures an element (for example, oxygen) from the functional layer 3 can be avoided, and a case in which performance of the functional layer 3 is affected because a metal element in the second conductive layer 5 penetrates into the functional layer 3 can be avoided. In this way, generation of a dead layer and penetration of an isolated element can be avoided, electrical performance and endurance of the prepared memory 100 can be improved, and a service life of the prepared memory 100 can be prolonged.

It may be understood that, in this application, a plurality of first passivation parts 2 that encircles a same first hole K1 may be equivalent to the passivation layer P1 in the foregoing implementation. Therefore, a plurality of self-aligned passivation parts may also be referred to as a self-aligned passivation layer.

It can be learned from the foregoing that, in this application, the first passivation part 2 may be used to replace the passivation layer P1 in the foregoing implementation. In this application, a plurality of mutually independent first passivation parts 2 may be selectively disposed in first conductive layers 11 based on positions of to-be-formed first holes, so that in this application, the first passivation part 2 and the first conductive layer 11 are located at a same layer, different first passivation parts 2 located at different layers are separated by the second dielectric layer 12, and the first passivation parts 2 located at the different layers are penetrated to form the first hole K1. Therefore, in this application, sizes of the different first passivation parts 2 are uniform along the radial direction of the first hole K1, instead of continuously covering the side wall of the first hole K1. This can avoid a problem caused by introduction of the vertical continuous passivation layer P1, for example, avoid leakage between the different first conductive layers 11 and interference caused by leakage caused by introduction of the vertical continuous passivation layer P1.

In addition, in this application, the first passivation part 2 is used to replace the passivation layer P1 in the foregoing implementation, so that not only introduction of the passivation layer P1 can be avoided, and pollution caused by introduction of another element oxide can be avoided, but also good contact between the first passivation part 2 and the first conductive layer 11 can be ensured, thereby avoiding a problem that the first passivation part 2 is difficult to be in good contact with the first conductive layer 11 because the passivation layer P1 is uneven in thickness.

In addition, this application can provide a flat self-aligned interface and the flat side wall. Therefore, compared with that in the passivation layer P1 introduced in the foregoing implementation, control on thickness uniformity, flatness, and retention of the passivation layer P1 can be omitted. This not only can simplify the preparation method for a memory, and reduce a difficulty in preparing the memory, but also can improve yields of the functional layer 3, the first passivation layer 4, and the second conductive layer 5 that are subsequently deposited and formed in the first hole K1, and further improve a yield of the prepared memory 100.

It should be noted that in S100b, there are a plurality of methods for forming the first composite layer 1a, and the methods may be selected and set based on an actual requirement. This is not limited in this application.

In some examples, forming the first composite layer 1a includes S110a to S130a.

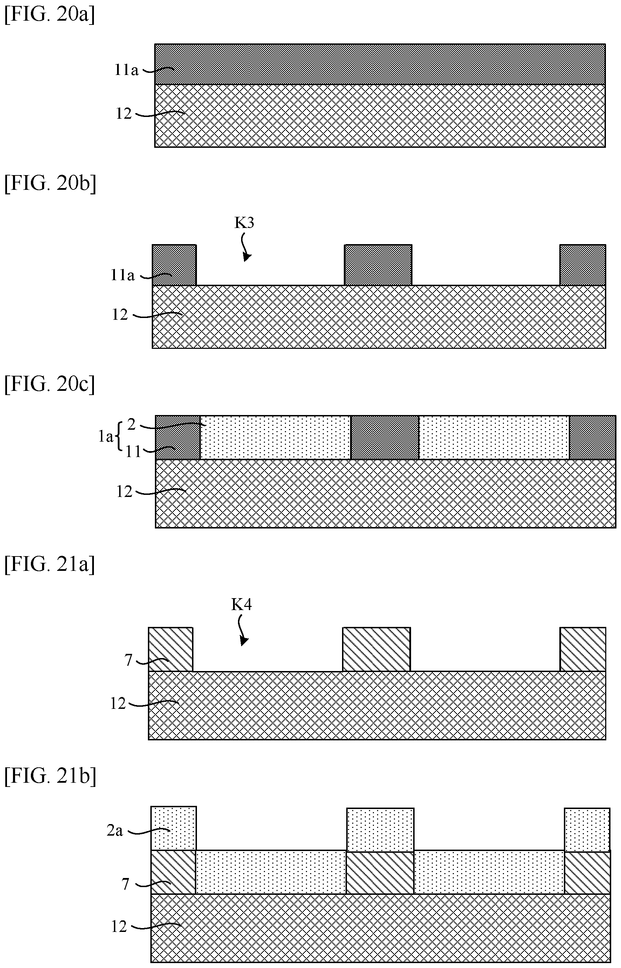

S110a: Form a first conductive thin film 11a, as shown in FIG. 20a.

For example, in this application, the first conductive thin film 11a may be formed by using thin film deposition processes such as CVD, PVD, ALD, or any combination thereof.

S120a: Pattern the first conductive thin film 11a to form a first opening K3, to obtain a first conductive layer 11, as shown in FIG. 20b.

For example, in this application, the first conductive thin film 11a may be patterned by using a photolithography process or another etching process, to form a plurality of first openings K3. A position of the formed first opening K3 corresponds to a position of a to-be-formed first opening K3

S130a: Form a first passivation part 2 in the first opening K3, as shown in FIG. 20c.

For example, in this application, the first passivation part 2 may be formed in each first opening K3 by using thin film deposition processes such as CVD, PVD, ALD, or any combination thereof.

In some other examples, forming the first composite layer 1a includes S110b to S130b, and S140b-1 to S160b-1 or S140b-2 and S150b-2.

S110b: Form a first stripping layer 7, as shown in FIG. 21a. The first stripping layer 7 has a second opening K4 corresponding to a to-be-formed first passivation part.

For example, in this application, a first stripping thin film may be formed by using a coating process, and then patterning processing is performed on the first stripping thin film by using a photolithography process or another etching process, to form a plurality of second openings K4, to obtain the first stripping layer 7.

S120b: Form a first passivation thin film 2a on the first stripping layer 7, as shown in FIG. 21b.

For example, in this application, the first passivation thin film 2a may be formed on the first stripping layer 7 by using thin film deposition processes such as CVD, PVD, ALD, or any combination thereof. A part of the first passivation thin film 2a is located in each of the plurality of second openings K4, and the other part covers the first stripping layer 7.

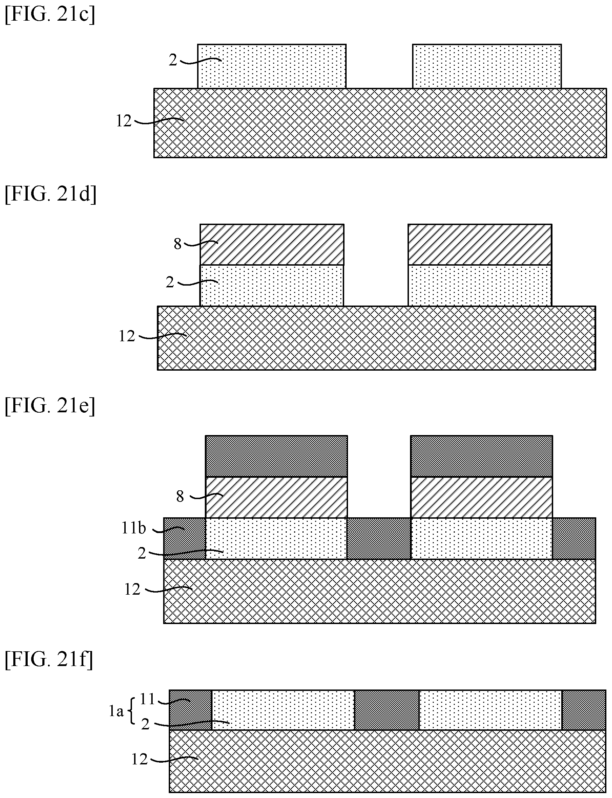

S130b: Remove the first stripping layer 7 and the part that is of the first passivation thin film 2a and that covers the first stripping layer 7, to obtain a first passivation part 2, as shown in FIG. 21c.

The first stripping layer 7 is stripped, so that the part that is of the first passivation thin film 2a and that covers the first stripping layer 7 may be removed while the first stripping layer 7 is removed, and the part that is of the first passivation thin film 2a and that is located in the second opening K4 is reserved, so as to obtain a plurality of first passivation parts 2. The plurality of second openings K4 are disposed independently of each other. Therefore, the plurality of obtained first passivation parts 2 are also disposed independently of each other.

Next, there are a plurality of methods for forming the first conductive layer 11, and the methods may be selected and set based on an actual requirement.

For example, the method for forming the first conductive layer 11 includes S140b-1 to S160b-1.

S140b-1: Form a second stripping layer 8 on the first passivation part 2, as shown in FIG. 21d. An orthographic projection of the second stripping layer 8 on a reference plane coincides with an orthographic projection of the first passivation part 2 on the reference plane, and the reference plane is a plane on which the memory 100 is located.

For example, in this application, a second stripping thin film may be formed by using a coating process, and then patterning processing is performed on the second stripping thin film by using a photolithography process or another etching process, to reserve a part that is of the second stripping thin film and that covers each first passivation part 2, and remove a part that is of the second stripping thin film and that does not cover each first passivation part 2, to obtain the second stripping layer 8. A shape of the second stripping layer 8 is the same as shapes of the plurality of formed first passivation parts 2.

S150b-1: Form a first conductive thin film 11b on the second stripping layer 8, as shown in FIG. 21e.

For example, in this application, the first conductive thin film 11b may be formed on the second stripping layer 8 by using thin film deposition processes such as CVD, PVD, ALD, or any combination thereof. A part of the first conductive thin film 11b covers the second stripping layer 8, and the other part is located between any two adjacent first passivation parts 2.

S160b-1: Remove the second stripping layer 8 and the part that is of the first conductive thin film 11b and that covers the second stripping layer 8, to obtain the first conductive layer 11, as shown in FIG. 21f.

The second stripping layer 8 is stripped, so that the part that is of the first conductive thin film 11b and that covers the second stripping layer 8 may be removed while the second stripping layer 8 is removed, and the part that is of the first conductive thin film 11b and that does not cover the second stripping layer 8 is reserved, that is, the part that is of the first conductive thin film 11b and that is located between the any two adjacent first passivation parts 2 is reserved, to obtain the first conductive layer 11.

For another example, the method for forming the first conductive layer 11 includes S140b-2 and S150b-2.

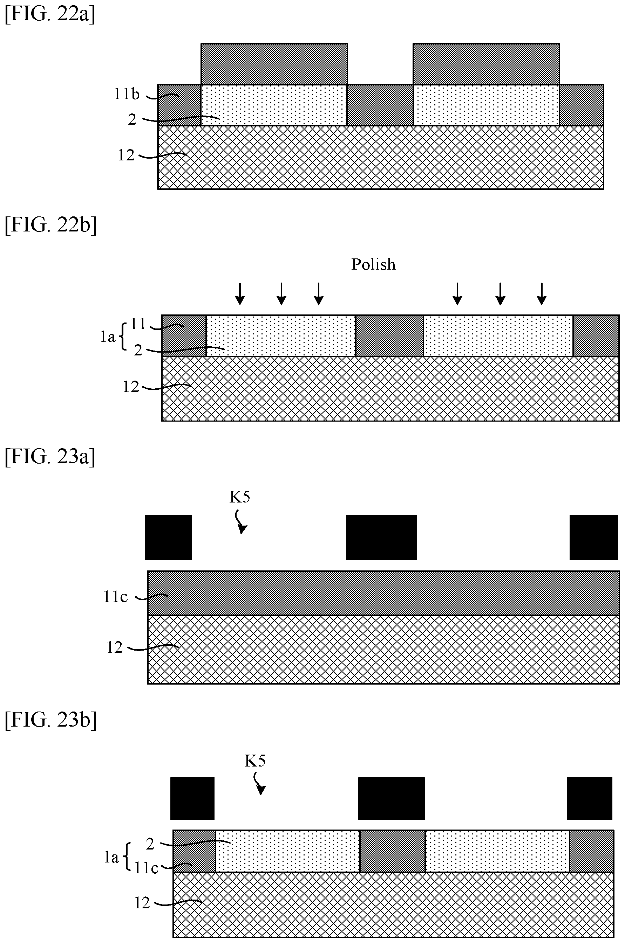

S140b-2: Form a first conductive thin film 11b on the first passivation part 2, as shown in FIG. 22a.

For example, in this application, the first conductive thin film 11b may be formed on the first passivation part 2 by using thin film deposition processes such as CVD, PVD, ALD, or any combination thereof. A part of the first conductive thin film 11b covers the first passivation part 2, and the other part is located between any two adjacent first passivation parts 2.

S150b-2: Polish the first conductive thin film 11b, and remove the part that is of the first conductive thin film 11b and that covers the first passivation part 2, to obtain the first conductive layer 11, as shown in FIG. 22b.

For example, in this application, a CMP (chemical mechanical polish, chemical mechanical polish) process may be used to polish the first conductive thin film 11b, to polish off the part that is of the first conductive thin film 1 1b and that covers the first passivation part 2, and reserve the part that is of the first conductive thin film 11b and that is located between the any two adjacent first passivation parts 2, to obtain the first conductive layer 11. For example, a surface of the first conductive layer 11 is flush with a surface of the first passivation part 2.

In some other examples, forming the first composite layer 1a includes S110c to S130c.

S110c: Form a first conductive thin film 11c, as shown in FIG. 23a.

For example, in this application, the first conductive thin film 11c may be formed by using thin film deposition processes such as CVD, PVD, ALD, or any combination thereof.

S120c: Dispose a mask on the first conductive thin film 11a, where the mask has a third opening K5 corresponding to a to-be-formed first passivation part, as shown in FIG. 23a.

For example, in the first conductive thin film 11a, a part of the to-be-formed first passivation part is exposed by the third opening K5, and a remaining part is shielded by the mask.

S130c: Perform oxidation processing on the first conductive thin film 11c via the third opening K5 of the mask, to form the first passivation part 2, as shown in FIG. 23b.

For example, in this application, oxidation processing may be performed, by using a thermal oxidation process, a dry oxygen oxidation process, a wet oxygen oxidation process, an oxygen plasma (O₂ Plasma) processing process, an ozone plasma (O₃ Plasma) processing process, an ion implantation process, an anodic oxidation process, or another oxidation process, on the part that is of the first conductive thin film 11c and that is exposed by the third opening K5, to form the first passivation part 2.

In some embodiments, before the first laminated structure 1 is formed, the foregoing preparation method further includes another step, and the another step may be selected and disposed based on an actual requirement. This is not limited in this application.

In some examples, before S100b, that is, before the first laminated structure 1 is formed, the preparation method further includes S010b to S050b.

S010b: Form a first conductive block 61, as shown in FIG. 15a.

S020b: Form a second conductive block 62 on the first conductive block 61, as shown in FIG. 15b.

S030b: Form a second hole K2 that penetrates the second conductive block 62, as shown in FIG. 15c. The second hole K2 exposes a part of the first conductive block 61.

S040b: Sequentially form a first dielectric layer 63 and a semiconductor layer 64 in the second hole K2, as shown in FIG. 15d.

S050b: Form a third conductive block 65 on the first dielectric layer 63 and the semiconductor layer 64, as shown in FIG. 15e. The third conductive block 65 is in contact with the semiconductor layer 64.

It should be noted that steps in S010b to S050b are basically the same as corresponding steps in S010a to S050a in some of the foregoing examples. Details are not described herein again.

In some other examples, before S100b, that is, before the first laminated structure 1 is formed, the preparation method further includes S060b to S090b.

S060b: Form a first conductive block 61, as shown in FIG. 15a.

For example, for a process of forming the first conductive block 61, refer to the process of forming the first conductive block 61 in S010a. Details are not described herein again.

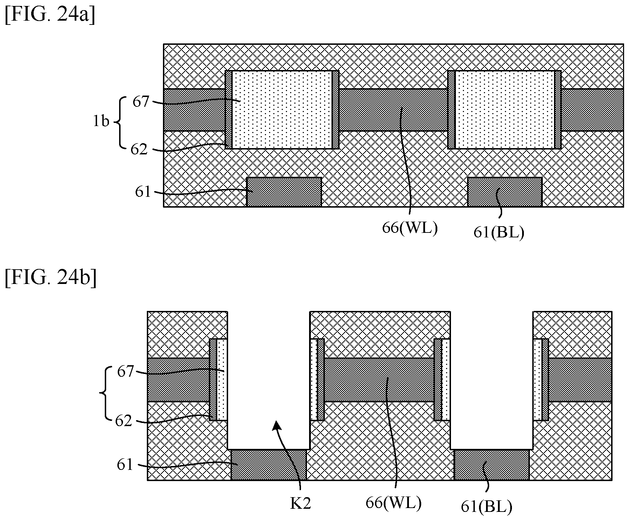

S070b: Form a second composite layer 1b on the first conductive block 61, where the second composite layer 1b includes a second passivation part 67 and a second conductive block 62 that encircles the second passivation part 67, as shown in FIG. 24a. A material of the second passivation part 67 is oxide of a material of the second conductive block 62.

For example, for a process of forming the second composite layer 1b, refer to the process of forming the first composite layer 1a. For the material of the second conductive block 62 and the material of the second passivation part 67, refer to the foregoing descriptions. Details are not described herein again.

S080b: Form a second hole K2 that penetrates the second passivation part 67, as shown in FIG. 24b. The second hole K2 exposes a part of the first conductive block 61.

For example, in this application, the second hole K2 that penetrates the second passivation part 67 may be formed by using a photolithography process, a dry etching process, another etching process, or the like.

S090b: Sequentially form a first dielectric layer 63, a second passivation layer 68, and a semiconductor layer 64 in the second hole K2, as shown in FIG. 16b.

For example, in this application, the first dielectric layer 63, the second passivation layer 68, and the semiconductor layer 64 may be sequentially formed by using thin film deposition processes such as CVD, PVD, ALD, or any combination thereof.

It may be understood that, the second passivation part 67 is formed between the first dielectric layer 63 and the second conductive block 62, and the second passivation part 67 may separate the first dielectric layer 63 from the second conductive block 62, to avoid generation of element penetration or capturing between the first dielectric layer 63 and the second conductive block 62, thereby avoiding impact on performance of the first dielectric layer 63 and the second conductive block 62, and avoiding impact on performance and a service life of the prepared memory 100.

Because main elements of the materials of the second conductive block 62 and the second passivation part 67 are the same, not only pollution caused by introduction of another element oxide can be avoided, but also a good interface can be provided between the second conductive block 62 and the second passivation part 67 at a same layer as the second conductive block 62, so that the second conductive block 62 and the second passivation part 67 at the same layer as the second conductive block 62 can be better combined.

In this application, a method for preparing and forming the second passivation part 67 is simple. The second passivation part 67 can be introduced and a flat side wall can be obtained without a need to deposit an insulation material on the side wall of the second hole K2 by using a deposition process with a high difficulty. The side wall is flat. This helps improve a yield of a film layer subsequently formed in the second hole K2, thereby improving a yield of the prepared memory 100.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory, wherein the memory comprises:
a first laminated structure having a first hole that penetrates the first laminated structure, wherein the first laminated structure comprises a plurality of first conductive layers that are stacked;
a first passivation part that is located in the first conductive layer and that is at a same layer as the first conductive layer, wherein the first passivation part encircles the first hole, and a material of the first passivation part is oxide of a material of the first conductive layer; and
a functional layer, a first passivation layer, and a second conductive layer that are disposed in the first hole, wherein the functional layer, the first passivation layer,
and the second conductive layer are sequentially arranged along a radial direction of the first hole and along a direction from a side wall of the first hole to an axis of the first hole.

2. The memory according to claim 1, wherein the memory further comprises:
a second laminated structure that is stacked with the first laminated structure; and
the second laminated structure comprises:
a first conductive block disposed on one side of the first laminated structure;
a second conductive block disposed between the first conductive block and the first laminated structure, wherein the second conductive block has a second hole;
a first dielectric layer and a semiconductor layer that are disposed in the second hole, wherein the first dielectric layer and the semiconductor layer are sequentially arranged along a radial direction of the second hole and along a direction from a side wall of the second hole to an axis of the second hole, and
the semiconductor layer is in contact with the first conductive block; and
a third conductive block disposed between the second conductive block and the first laminated structure, wherein the third conductive block is in contact with
the semiconductor layer and the second conductive layer.

3. The memory according to claim 2, wherein the second laminated structure further comprises:
a second passivation part that is disposed between the first dielectric layer and
the second conductive block and that is at a same layer as the second conductive block, wherein a material of the second passivation part is oxide of a material of the second conductive block; and
a second passivation layer disposed between the first dielectric layer and the semiconductor layer.

4. The memory according to any one of claims 1 to 3, wherein the functional layer comprises a ferroelectric thin film, a resistive thin film, or a charge trapping layer.

5. The memory according to claim 4, wherein when the functional layer comprises
the ferroelectric thin film or the resistive thin film, a material of the second conductive layer comprises a metal material; or
when the functional layer comprises the charge trapping layer, a material of the second conductive layer comprises a semiconductor material.

6. The memory according to claim 1, wherein the material of the first passivation part comprises at least one of tungsten oxide, titanium oxynitride, titanium oxide, tantalum oxynitride, tantalum oxide, silicon oxide, copper oxide, silver oxide, hafnium oxide, nickel oxide, ruthenium oxide, iridium oxide, molybdenum oxide, aluminum oxide, magnesium oxide, zinc oxide, and zirconium oxide.

7. The memory according to claim 1, wherein the first laminated structure further comprises a second dielectric layer disposed between two adjacent first conductive layers.

8. The memory according to claim 3, wherein the material of the second passivation part comprises at least one of tungsten oxide, titanium oxynitride, titanium oxide, tantalum oxynitride, tantalum oxide, silicon oxide, copper oxide, silver oxide, hafnium oxide, nickel oxide, ruthenium oxide, iridium oxide, molybdenum oxide, aluminum oxide, magnesium oxide, zinc oxide, and zirconium oxide.

9. A preparation method for a memory, wherein the preparation method comprises:
forming a first laminated structure, wherein the first laminated structure comprises a plurality of first conductive layers that are stacked;
forming a first hole that penetrates the first laminated structure;
performing, via the first hole, oxidation processing on a part that is of the first conductive layer and that encircles the first hole, to form a first passivation part; and
sequentially forming a functional layer, a first passivation layer, and a second conductive layer in the first hole.

10. The preparation method according to claim 9, wherein before the forming a first laminated structure, the preparation method further comprises:
forming a first conductive block;
forming a second conductive block on the first conductive block;
forming a second hole that penetrates the second conductive block, wherein the second hole exposes a part of the first conductive block;
sequentially forming a first dielectric layer and a semiconductor layer in the second hole; and
forming a third conductive block on the first dielectric layer and the semiconductor layer, wherein the third conductive block is in contact with the semiconductor layer.

11. The preparation method according to claim 10, wherein before the sequentially forming a first dielectric layer and a semiconductor layer in the second hole, the preparation method further comprises:
performing, via the second hole, oxidation processing on a part that is of the second conductive block and that encircles the second hole, to form a second passivation part; and
before the forming a semiconductor layer, the preparation method further comprises:
forming a second passivation layer.

12. A preparation method for a memory, wherein the preparation method comprises:
forming a first laminated structure, wherein the first laminated structure comprises a plurality of first composite layers that are stacked, the first composite layer comprises a first passivation part and a first conductive layer that encircles the first passivation part, and a material of the first passivation part is oxide of a material of the first conductive layer;
forming a first hole that penetrates the first passivation part; and
sequentially forming a functional layer, a first passivation layer, and a second conductive layer in the first hole.

13. The preparation method according to claim 12, wherein forming the first
composite layer comprises:
forming a first conductive thin film;
patterning the first conductive thin film to form a first opening, to obtain the first conductive layer; and
forming the first passivation part in the first opening.

14. The preparation method according to claim 12, wherein forming the first composite layer comprises:
forming a first stripping layer, wherein the first stripping layer has a second opening corresponding to a to-be-formed first passivation part; forming a first passivation thin film on the first stripping layer; and removing the first stripping layer and a part that is of the first passivation thin film and that covers the first stripping layer, to obtain the first passivation part; and
forming a second stripping layer on the first passivation part, wherein an orthographic projection of the second stripping layer on a reference plane coincides with an orthographic projection of the first passivation part on the reference plane, and the reference plane is a plane on which the memory is located; forming a first conductive thin film on the second stripping layer; and
removing the second stripping layer and a part that is of the first conductive thin film and that covers the second stripping layer, to obtain the first conductive layer; or
forming a first conductive thin film on the first passivation part; and polishing the first conductive thin film, and removing a part that is of the first conductive thin film and that covers the first passivation part, to obtain the first conductive layer.

15. The preparation method according to claim 12, wherein forming the first composite layer comprises:
forming a first conductive thin film;
disposing a mask on the first conductive thin film, wherein the mask has a third opening corresponding to a to-be-formed first passivation part; and
performing oxidation processing on the first conductive thin film via the third opening of the mask, to form the first passivation part.

16. The preparation method according to any one of claims 12 to 15, wherein before the forming a first laminated structure, the preparation method further comprises:
forming a first conductive block;
forming a second conductive block on the first conductive block;
forming a second hole that penetrates the second conductive block, wherein the second hole exposes a part of the first conductive block;
sequentially forming a first dielectric layer and a semiconductor layer in the second hole; and
forming a third conductive block on the first dielectric layer and the semiconductor layer, wherein the third conductive block is in contact with the semiconductor layer.

17. The preparation method according to any one of claims 12 to 15, wherein before
the forming a first laminated structure, the preparation method further comprises:
forming a first conductive block;
forming a second composite layer on the first conductive block, wherein the second composite layer comprises a second passivation part and a second conductive block that encircles the second passivation part, and a material of the second passivation part is oxide of a material of the second conductive block;
forming a second hole that penetrates the second passivation part, wherein the second hole exposes a part of the first conductive block; and
sequentially forming a first dielectric layer, a second passivation layer, and a semiconductor layer in the second hole.

18. An electronic device, wherein the electronic device comprises a processor and a memory coupled to the processor, and the memory comprises the memory according to any one of claims 1 to 8.
